(19) Europäisches Patentamt
European Patent Office
Office européen des brevets

(11) **EP 3 125 397 B1**

(12) **EUROPÄISCHE PATENTSCHRIFT**

(45) Veröffentlichungstag und Bekanntmachung des Hinweises auf die Patenterteilung:
**17.07.2019 Patentblatt 2019/29**

(51) Int Cl.:
***H02J 3/38*** *(2006.01)*

(21) Anmeldenummer: **15178794.2**

(22) Anmeldetag: **29.07.2015**

(54) **VERFAHREN, DATENVERARBEITUNGSANORDNUNG UND COMPUTERPROGRAMMPRODUKT ZUR NACHRÜSTUNG EINES ELEKTRISCHEN ENERGIENETZES**

METHOD, DATA PROCESSING ASSEMBLY AND COMPUTER PROGRAM PRODUCT FOR RETROFITTING AN ELECTRICAL ENERGY NETWORK

PROCÉDÉ, ENSEMBLE DE TRAITEMENT DE DONNÉES ET PRODUIT DE PROGRAMME INFORMATIQUE POUR AMÉLIORER UN RÉSEAU D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.02.2017 Patentblatt 2017/05**

(73) Patentinhaber: **Siemens Aktiengesellschaft 80333 München (DE)**

(72) Erfinder: **Blug, Christian 66287 Quierschied (DE)**

(56) Entgegenhaltungen:
**WO-A2-2014/152408     US-A1- 2009 276 170
US-A1- 2015 088 439**

**Beschreibung**

Die Erfindung betrifft ein Verfahren zur Nachrüstung eines elektrischen Energienetzes gemäß Anspruch 1 sowie eine entsprechende Anordnung gemäß Anspruch 7 sowie ein Computerprogrammprodukt nach Anspruch 12.

In öffentlichen Energienetzen, z.B. Energieverteilungs- und Energieübertragungsnetzen, tritt aufgrund der stark heterogenen Last- und Erzeugerstruktur durch dezentrale Energieerzeuger die Aufrechterhaltung der Spannungsqualität immer mehr in den Vordergrund. Es muss z.B. die Norm EN 50160 eingehalten werden, die ein Spannungsband von +/- 10% der Nennspannung des Energienetzes für alle Netzbetriebsfälle fordert. Dies wird mit den konventionellen Regelverfahren (statische Regelung in den Ortsnetzstationen (ONS) und den Umspannwerken) immer schwieriger. Daher werden zunehmend regelbare Ortsnetztransformatoren (RONT) oder Netzregler eingesetzt. Ein Beispiel für diese Problematik und entsprechend eingesetzte RONT und Netzregler findet sich in dem Vortrag "Pilotprojekte zur Spannungsregelung im NS-Netz der Thüringer Energie", VDE-Symposium, Meissen 18.9.2013, von Dipl.-Ing. Torsten Roscher, Thüringer Energie AG aus Erfurt.

Die Auswahl der Produkte sowie deren Aufstellungsorte erfolgt aufgrund von Feldversuchen oder betrieblichen Erfahrungswerten. Die Koordination mit den im Netz weiterhin vorhandenen Regeleinrichtungen muss aufgrund der Komplexität entfallen oder erfolgt nur rudimentär durch Versuche. Eine solche Vorgehensweise ist daher sowohl betrieblich als auch wirtschaftlich nicht optimal. Um bei der Planung eines Energienetzes zu einer sowohl unter den Aspekten Energieverluste als auch Investitionskosten zu einem optimalen Ergebnis zu kommen, müssten alle Regeleinrichtungen (Sollwert im Umspannwerk, Bau oder Nicht-Bau von Mittelspannungsnetzreglern, Einstellung der Stufensteller in den konventionellen ONS, Austausch von ausgewählter ONS-Trafos gegen RONT, Einbau von Netzreglern in der Niederspannung) für alle relevanten Betriebsfälle in Betracht gezogen werden.

RONT sind bei zahlreichen Herstellern im Angebot, wobei sich die unterschiedlichen Geräte in ihren Möglichkeiten zur Spannungsregelung, bei den Anschaffungs- und Wartungskosten sowie den bauartbedingten Energieverlusten unterscheiden. Regelbare Ortsnetztransformatoren weisen i.d.R Preise zwischen 22000 Euro bis 25000 Euro auf und sind derzeit daher ca. doppelt so teuer wie konventionelle Ortsnetztransformatoren. Daher sollten der Einsatz und der Aufstellungsort eines RONT genau geplant werden. Dabei bezeichnet der so genannte Barwert die Anschaffungskosten zuzüglich kumulierter Betriebskosten über die geplante Betriebsdauer eines Betriebsmittels wie etwa eines Transformators.

Mit Bezug auf den betriebsbedingten Energieverlust der verschiedenen Gerätetypen müssen i.d.R. Testmessungen in verschiedenen Betriebssituationen vorgenommen werden. Dabei muss häufig bei einer hohen Flexibilität, z.B. wenn viele unterschiedliche Regelstufen an einem Transformator vorgesehen sind, ein erhöhter Energieverlust aufgrund einer aufwändigeren Konstruktion in Kauf genommen werden.

Beispielsweise ist aus der Informationsbroschüre "Die intelligente Ortsnetzstation - Ein wichtiger Smart Grid-Baustein", SEEDEFOSMARTKIOSK_12-12_1.1 aus 2012 von Schneider Electric Energy GmbH, auf Seite 7 ein stufenlos elektronisch regelbarer Ortsnetztransformator bekannt.

Aus der Produktinformation "FITformer® REG - Der regelbare Ortsnetztransformator", Bestell-Nr. E50001-G640-A220-V2, TH 101-140819 DB 10140.3 aus dem Jahr 2014, ist ein dreistufiger Transformator bekannt.

Netzregler sind zum Beispiel aus der Produktinformation "Netzregler" von Walcher GmbH & Co. KG bekannt. Auch aus der Produktinformation "Magtech-Netzregler: Spezialist für Netzausläufer mit Photovoltaik-Anlagen" ist ein Netzregler bekannt.

Aus der Druckschrift WO 2012/037989 A1 ist ein Verfahren zur rechnergestützten Energieverteilung in einem dezentralen Energienetz bekannt, bei dem im Betrieb des Energienetzes mittels eines mathematischen Optimierungsverfahrens eine verbesserte Regelung von Wirkleistungen, die in verschiedenen Punkten des Energienetzes zur Verfügung gestellt werden, vorgeschlagen wird. Dabei wird vor allem der Energieverbrauch bzw. die Energieeinspeisung dezentraler Energieverbraucher bzw. Energieerzeuger anhand einer Auswertung von Messwerten gesteuert.

Ferner ist aus der Druckschrift WO 2010/0357516 A1 ein Verfahren zur Ermittlung elektrischer Lastflüsse in einem elektrischen Energieversorgungsnetz bekannt, wobei Lastprofile von Verbrauchern dynamisch anhand von Messwerten im Betrieb des Energieversorgungsnetzes angepasst werden.

Es ist dabei bisher üblich, in Bezug auf die Planung eines Energienetzes aufgrund der Komplexität eines typischen Energienetzes und seiner regelbaren Einrichtungen bei der Planung nur Teilaspekte zu untersuchen. Hierzu werden im Rahmen einiger weniger, von einem Planer ausgedachten Varianten mögliche Standorte von RONT vorgegeben und mit Hilfe von Lastflusssimulationen evaluiert. Aufgrund der hohen Anzahl von Lösungsmöglichkeiten müssen bei dieser Vorgehensweise Teilaspekte oder Korrelationen zwischen den Aspekten ganz vernachlässigt werden, um in endlicher Zeit ein Resultat zu erzielen.

Alternativ hierzu werden seit langem auch langwierige Feldversuche bzw. Messungen zur Unterstützung der Lösungsfindung durchgeführt.

Ein gattungsgemäßes Verfahren ist aus der Druckschrift WO 2014/152408 A2bekannt. Ferner sind die Druckschriften US 2015/088439 A1 und US 2009/276170 A1 bekannt, die sich mit der Optimierung von Energienetzen befassen.

An die Erfindung stellt sich ausgehend von bekannten Ansätzen zur Planung eines elektrischen Energienetzes mit regelbaren Einrichtungen zur Energieübertragung die technische Aufgabe, ein Verfahren zur Nachrüstung des Energienetzes anzugeben, das mit vergleichsweise geringen Nachrüstungsaufwänden und/oder Energieverlusten eine hohe Spannungsqualität auch bei vermehrter dezentraler Energieeinspeisung ermöglicht.

Die Erfindung löst diese Aufgabe durch ein Verfahren gemäß Anspruch 1.

Unter regelbaren Einrichtungen sind dabei im Rahmen der Erfindung Einrichtungen zu verstehen, mittels derer eine Spannung geregelt werden kann. Beispielsweise ist ein regelbarer Ortsnetztransformator eine regelbare Einrichtung. Eine Regelstellung ist dabei z.B. eine Stufenstellung eines stufenweise-regelbaren Ortsnetztransformators. Allgemein gibt die Regelstellung an, inwieweit (z.B. +3,5 %) die regelbare Einrichtung von ihrem Normalwert (z.B. im Niederspannungsbereich 230V = 100 %) für die Ausgangsspannung abweichen soll. Das bestehende Energienetz kann dabei bereits regelbare Einrichtungen zur Energieübertragung enthalten, zu denen noch weitere zusätzliche regelbare Einrichtungen nachgerüstet werden sollen, um im Betrieb des Energienetzes das vorgegebene Spannungsband einzuhalten.

Das Modell des Energienetzes berücksichtigt im einfachsten Fall nur eine Spannungsverteilung und ist daher i.d.R. unterschiedlich zu Lastflussmodellen bzw. Netzmodellen wie sie in der Netzplanung üblicherweise eingesetzt werden.

Die Regeleinstellungen vorhandener Regeleinrichtungen sowie die Standorte/Regeleinstellungen neuer erforderlicher Regeleinrichtungen werden dabei so gewählt, dass die Zielfunktion minimiert wird.

Nachrüstungsaufwände im Sinne der Erfindung sind Aufwände, die z.B. entstehen, wenn durch entsprechendes Personal bestehende Transformatoren durch RONT ersetzt werden. Dabei muss zumindest der dem bestehenden Transformator nachgeordnete Netzteil abgeschaltet werden, um den Umbau vorzunehmen. Dies bedeutet eine verminderte Verfügbarkeit des Energienetzes für Kunden, was nachteilig ist. Außerdem müssen auch die Regelstellungen anderer regelbarer Einrichtungen angepasst werden, was ebenfalls zu Personalaufwand, Kosten und verringerter Verfügbarkeit führt. Wie deutlich wird, umfasst der Begriff Nachrüstungsaufwände Zeit und Kosten für den Umbau des Energienetzes anhand des Ergebnisses der Simulation. I.d.R. sind die Nachrüstungsaufwände am Kleinsten, wenn nur eine möglichst kleine Anzahl von regelbaren Einrichtungen ersetzt und nur eine möglichst kleine Anzahl von bestehenden regelbaren Einrichtungen mit einer anderen Regelstellung versehen werden muss.

Energieverluste im Sinne der Erfindung sind Verluste an elektrischer Energie in den regelbaren Einrichtungen, die z.B. in einem Transformator entstehen, der mit einer vorgegebenen Regelstellung betrieben wird.

Es ist ein wesentlicher Vorteil des erfindungsgemäßen Verfahrens, dass durch die Minimierung der Zielfunktion eine Optimierung vorgenommen werden kann, die zu besonders geringen Aufwänden, Energieverlusten und Kosten für die Nachrüstung führt. Im Gegensatz dazu werden bei einer herkömmlichen Nachrüstung eines Energienetzes häufig zusätzliche Blindleistungsquellen eingesetzt, was jedoch zu höheren Strömen im Energienetz und damit auch größeren Netzverlusten führt.

In einer bevorzugten Ausführungsform des erfindungsgemäßen Verfahrens wird ein lineares Gleichungssystem und/oder Ungleichungssystem verwendet. Dies ist ein Vorteil, weil auf diese Weise eine effizient und vergleichsweise schnell zu lösendes mathematisches Modell bzw. eine Simulation verwendet werden kann, die die Spannungsbedingungen als lineares (Un-) Gleichungssystem in Abhängigkeit der Regelstellungen aller vorhandenen und als neu einzubauenden Regeleinrichtungen formuliert. Zur Berechnung stehen bereits leistungsfähige Solver zur Verfügung. Im Rahmen der Evaluierung des Modells kann beispielsweise der kostenfreie Solver lp_solve eingesetzt werden, der im Internet an zahlreichen Adressen zum Download verfügbar ist.

In einer weiteren bevorzugten Ausführungsform des erfindungsgemäßen Verfahrens wird das Ergebnis verwendet, um an der angegebenen Position im Energienetz die zusätzlich benötigten regelbaren Einrichtungen nachzurüsten. Dabei wird i.d.R. auch die Regelstellung der regelbaren Einrichtung und aller weiteren, bereits vorhandenen regelbaren Einrichtungen entsprechend des Ergebnisses eingestellt, was eine optimale Koordination von bestehenden und neuen Spannungsregeleinrichtungen bewirkt.

In einer weiteren bevorzugten Ausführungsform des erfindungsgemäßen Verfahrens werden als regelbare Einrichtungen ein Umspannwerktransformator mit regelbarer Ausgangsspannung und/oder stufenweise-regelbare Ortsnetztransformatoren und/oder stufenlos-regelbare Ortsnetztransformatoren und/oder Netzregler verwendet. Dies ist ein Vorteil, weil mittels der unterschiedlichen regelbaren Einrichtungen jeweils Anpassungen der Spannung in unterschiedlicher Höhe erfolgen kann, wobei die unterschiedlichen regelbaren Einrichtungen sich im Hinblick auf ihre Flexibilität im Hinblick auf die Spannungsregelung (z.B. die Anzahl der Stufen sowie prozentuale Spreizung der Stufen) und den Preis deutlich unterscheiden.

Dabei sind stufenweise-regelbare Ortsnetztransformatoren im Rahmen der Erfindung Einrichtungen, deren Ausgangsspannung in Stufen einstellbar ist. Beispielsweise sind drei Stufen mit 96 %, 100 % und 104 % des Normalwerts für die Ausgangsspannung möglich. Es gibt jedoch auch stufenlos-regelbare Ortsnetztransformatoren, bei denen z.B. einem Ortsnetztransformator auf seiner Niederspannungsseite ein Netzregler nachgeschaltet ist, der die Ausgangsspannung stufenlos zwischen 0 und 7 % ändern kann. Ein solcher stufenlos-regelbarer Ortsnetztransformator ist beispielsweise von der Firma MagTech bekannt.

Netzregler sind Transformatoren, deren Eingangsspannung und Ausgangsspannung auf dergleichen Spannungsebene angesiedelt ist. Sie können daher im Niederspannungsbereich als auch im Mittelspannungsbereich eingesetzt werden, um die Spannung zu regeln.

In einer weiteren bevorzugten Ausführungsform des erfindungsgemäßen Verfahrens beträgt das vorgegebene Spannungsband +/-10% einer vorgegebenen Nennspannung des Energienetzes. Dies ist ein Vorteil, weil dies ein gemäß verschiedener Normen häufig gefordertes zulässiges Spannungsband ist. Prinzipiell kann das erfindungsgemäße Verfahren jedoch alle Spannungsbänder unterschiedlicher Breite berücksichtigen, wenn dies konkret erforderlich sein sollte.

Es wird die Zielfunktion mittels einer gemischt-ganzzahligen Optimierung minimiert. Dies ist ein Vorteil, weil mit einer gemischt-ganzzahligen Optimierung schnell und einfach eine Lösung gefunden werden kann. Somit kommt das erfindungsgemäße Verfahren rasch und mit vergleichsweise geringem Rechenaufwand für die Simulation zu dem Ergebnis.

In einer weiteren bevorzugten Ausführungsform des erfindungsgemäßen Verfahrens wird als gemischt-ganzzahlige Optimierung ein Branch&Bound-Verfahren verwendet. Dies ist ein Vorteil, weil Branch&Bound-Verfahren weit verbreitet und lange erprobt sind.

In einer weiteren bevorzugten Ausführungsform des erfindungsgemäßen Verfahrens wird als Ergebnis für jede zusätzliche regelbare Einrichtung ein spezifischer Typ der Einrichtung eines spezifischen Herstellers angegeben. Dies ist ein Vorteil, weil sich unterschiedliche Gerätetypen von unterschiedlichen Herstellern in ihren technischen Fähigkeiten und Kosten deutlich unterscheiden. Beispielsweise ist es billiger und oft auch wartungsärmer im Betrieb, einen einfacheren Transformator mit lediglich drei Stufen anstatt eines komplexeren Transformators mit fünf Stufen einzusetzen, wenn an der im Ergebnis angegebenen Position im Energienetz auch ein drei-Stufenschalter ausreicht.

Ferner stellt sich an die Erfindung die technische Aufgabe, ausgehend von bekannten Ansätzen zur Planung eines elektrischen Energienetzes mit regelbaren Einrichtungen zur Energieübertragung, eine Datenverarbeitungsanordnung zur Nachrüstung des Energienetzes anzugeben, das mit vergleichsweise geringen Nachrüstungsaufwänden und/oder Energieverlusten eine hohe Spannungsqualität auch bei vermehrter dezentraler Energieeinspeisung ermöglicht.

Die Erfindung löst die obige Aufgabe auch durch eine Datenverarbeitungsanordnung gemäß Anspruch 7. Bevorzugte Ausführungsformen ergeben sich aus den abhängigen Ansprüchen 8 bis 11. Dabei ergeben sich für die erfindungsgemäße Datenverarbeitungsanordnung und ihre Ausführungsformen sinngemäß die gleichen Vorteile wie eingangs für das erfindungsgemäße Verfahren erläutert.

Weiterhin stellt sich an die Erfindung die technische Aufgabe, ausgehend von bekannten Ansätzen zur Planung eines elektrischen Energienetzes mit regelbaren Einrichtungen zur Energieübertragung, ein Computerprogrammprodukt anzugeben, mittels dessen das erfindungsgemäße Verfahren in einer Datenverarbeitungseinrichtung eingesetzt werden kann.

Die Erfindung löst die obige Aufgabe auch durch ein Computerprogrammprodukt gemäß Anspruch 12. Dabei ergeben sich für das erfindungsgemäße Computerprogrammprodukt sinngemäß die gleichen Vorteile wie eingangs für das erfindungsgemäße Verfahren erläutert.

Im Folgenden wird anhand eines Ausführungsbeispiels des erfindungsgemäßen Verfahrens erläutert, wie eine Simulation durchgeführt und das Ergebnis verwendet werden kann.

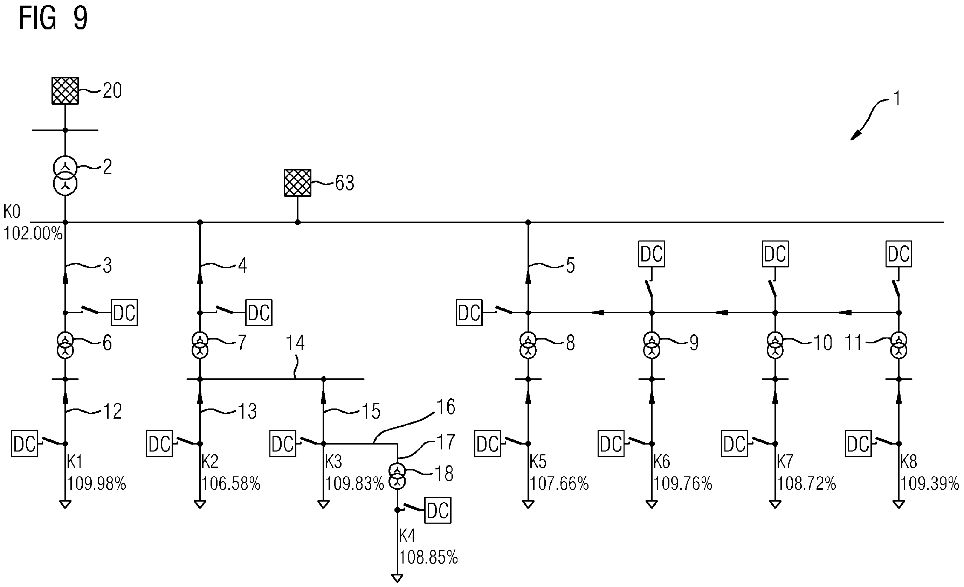

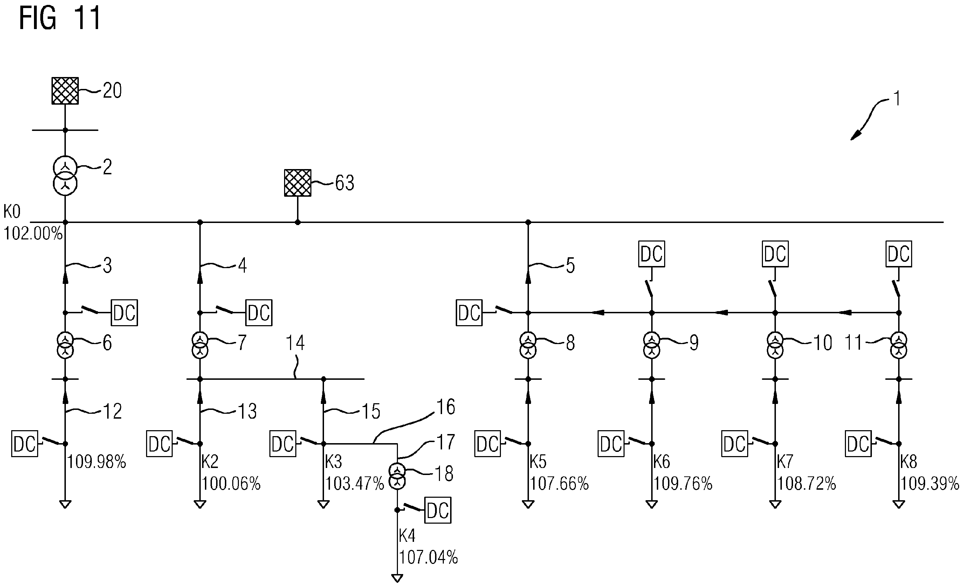

Dabei wird das Ausführungsbeispiel anhand der Figuren 1 bis 11 sowie der Tabellen 1 und 2 erläutert.

Es zeigen in schematischer Darstellung

Figur 1        ein Beispiel-Energienetz mit regelbaren Einrichtungen zur Energieübertragung und

Figur 2        als Simulationsergebnis bei Konstantleistung für einen Starklastfall im ersten Beispiel-Energienetz die Spannungsabweichung von der Nennspannung an den Knoten 1 bis 8 gemäß Figur 1 und

Figur 3        als Simulationsergebnis bei Konstantleistung für einen Fall mit starker Einspeisung im ersten Beispiel-Energienetz die Spannungsabweichung von der Nennspannung an den Knoten 1 bis 8 gemäß Figur 1 und

Figur 4        als Simulationsergebnis bei Konstantstrom für einen Starklastfall im ersten Beispiel-Energienetz die Spannungsabweichung von der Nennspannung an den Knoten 1 bis 8 gemäß Figur 1 und

Figur 5        eine Datenverarbeitungsanordnung zur Durchführung des erfindungsgemäßen Verfahrens und

Figur 6        das Beispiel-Energienetz gemäß Figur 1 für einen Starklastfall und

Figur 7        das Beispiel-Energienetz gemäß Figur 1 für einen Fall mit starker Einspeisung und

Figur 8          ein anhand eines ersten Simulationsergebnisses nachgerüstetes Beispiel-Energienetz im Starklastfall und

Figur 9          ein anhand des ersten Simulationsergebnisses nachgerüstetes Beispiel-Energienetz im Fall starker Einspeisung und

Figur 10        ein anhand eines zweiten Simulationsergebnisses nachgerüstetes Beispiel-Energienetz im Starklastfall und

Figur 11        ein anhand eines zweiten Simulationsergebnisses nachgerüstetes Beispiel-Energienetz im Fall starker Einspeisung und

Figur 12        das Beispielnetz gemäß Figur 1 mit erhöhter Mittelspannung am Knoten K0 und

Figur 13        Knotenspannungen unter Berücksichtigung von Korrekturtermen für Linearisierungsfehler und

Figur 14        Knotenspannungen bei optimiertem Einspeisemanagement

Figur 15        eine Regelkennlinie einer Compound-Regelung.

Die Methode ist an einem repräsentativen Beispielnetz evaluiert und ihre Wirksamkeit nachgewiesen worden.

Das Verfahren ermöglicht die umfassende Betrachtung aller Spannungsregelelemente bzw. regelbare Einrichtungen und ermöglicht somit zum ersten Mal eine vollständige Koordination aller Regelelemente: So werden z.B. die Stufenstellungen der statisch geregelten ONS derart gewählt und mit der Spannungsregelung im Umspannwerk abgestimmt, dass nur eine Minimalanzahl von neuen Regeleinrichtungen wie RONT und/oder Netzregler erforderlich sind. Dies ist vorteilhaft, weil Kosten eingespart werden können.

Das Verfahren ermöglicht analytisch die Bestimmung derjenigen Orte bzw. Positionen im Energienetz, an denen neue Netzregelelemente am sinnvollsten sind. Das Verfahren ermöglicht eine Abwägung, wann Netzregler und wann RONT eingesetzt werden sollen. Ferner kann die Auswahl der günstigsten Anbieter von Netzregelelementen in Abhängigkeit von Kosten und Regelbereichen der Geräte erfolgen, so dass nur minimale Kosten für den Netzbetreiber infolge einer Umrüstung entstehen.

Das erfindungsgemäße Verfahren kann z.B. eingesetzt werden für Netzstudien zu Spannungsregelkonzepten oder als Werkzeug zur optimalen Auslegung von RONT (Ermittlung und Bewertung der technisch-wirtschaftlich erforderlichen statischen und dynamischen RONT-Stufen). Weiterhin können in Anwendung des erfindungsgemäßen Verfahrens kundenspezifische Leittechnik-Projekte geplant werden. Das erfindungsgemäße Verfahren kann dabei z.B. als Software-Lösung bereit gestellt werden.

Es werden für die Simulation verschiedene regelbare Einrichtungen vorgesehen:

Siemens FITformer

Diese Lösung kombiniert einen stromlos betätigbaren Stufensteller auf der Oberspannungsseite (+/-2,5/5%) mit einem unter Last betätigbaren Schütz auf der Unterspannungsseite. Dessen Regelbereich ist symmetrisch ausgelegt und weist einen Lastregelbereich von +/- 3,57 %, bzw. +/- 4,35 % auf. Die variable Übersetzung wird über Abgriffe der sekundärseitigen Wicklung erreicht.

MR GridCon iTap

Diese Lösung von MR Reinhausen baut ebenfalls auf dem Prinzip der induktiven Übertragung auf. Dabei erfolgt die Stufung über einen unter Last betätigbaren Stufenschalter auf der Oberspannungsseite. Hier kann mit bis zu 9 Stufen je nach Anforderung ein symmetrischer oder asymmetrischer Betrieb realisiert werden.

MRONT Magtech

Bei dieser Lösung wird die magnetische Flussdichte im Eisenkern durch ein zusätzlich eingekoppeltes Gleich-Magnetfeld beeinflusst. Aufgrund dieses Prinzips kann die Flussdichte und damit die induzierte Spannung stufenlos verstellt werden.

Netzregler

Eine weitere Möglichkeit, die Netzspannung innerhalb der zulässigen Grenzen zu halten, sind Netzregler.

Hierunter versteht man ebenfalls einen induktiven Spannungsregler, der z.B. in den Strang eines langen Stichkabels eingebunden wird, um die Netzspannung der Knoten dieses Stichs zu regeln. Dabei gibt es sowohl mittel- als auch niederspannungsseitige Lösungen. Ein solcher Netzregler wird punktuell eingesetzt und muss nur für eine entsprechend kleinere Leistung im Vergleich zum RONT, bzw. Umspannwerkstransformator ausgelegt werden, so dass sich hier Kostenvorteile ergeben können. Sogenannte Voltage Booster wurden in der Vergangenheit eingesetzt, um zu große Spannungsfälle bei langen Ausläuferleitungen im Verteilnetz auszugleichen.

Netzregler Mittelspannung

Hier wird ein Spartransformator der Firma Siemens zum Ausgleich der Spannungsdifferenzen in einen Zweig geschaltet. Hierbei wird ein Preis von ca. 110000 Euro bis 140000 Euro genannt.

Netzregler Niederspannung

Ein solcher Netzregler der Firma Walcher arbeitet ebenfalls nach dem induktiven Übertragungsprinzip und besteht aus Transformatoren-Kaskaden je Phase. Der Preis hierfür ist leistungsabhängig, es wird jedoch für eine ausgewählte Lösung ein Preis von 16000 Euro genannt.

Zur Zielsetzung der Simulation:

Die Netzspannung kann ebenfalls durch Abnahme, bzw. Erzeugung induktiver Blindleistung der dezentralen Erzeuger beeinflusst werden. Dabei müssen momentan dezentrale Erzeuger mit Anschlusspunkt in der Mittelspannungsebene ihre Wirkleistung bei einem Leistungsfaktor von $\cos \phi = 0,95$ "untererregt" und "übererregt" abgeben können. In der Regel ist dabei der untererregte Betrieb von größerer Relevanz. Ein solcher Betrieb kann mit einer höheren Leitungsauslastung und zusätzlichen Netzverlusten verbunden sein, wenn nicht gerade Verbraucherblindleistung kompensiert wird. Es ist nun klar, dass im Sinne eines optimalen Netzbetriebs, aber auch einer kostenoptimalen Netzstruktur die einzelnen Optionen der betrieblichen Spannungsregelung zu koordinieren sind.
Es wird im Folgenden ein Verfahren dargestellt, das die Behandlung folgender Fragestellungen zum Gegenstand hat:

- Welches ist die kostengünstigste Auslegung der Stufensteller der konventionellen ONS?
- An welchen Stellen im Netz müssen RONT, bzw. Netzregler eingesetzt werden?
- Wie viele RONT oder Netzregler müssen im Netz eingesetzt werden?
- Welcher Spannungssollwert muss beim Umspanntransformator eingestellt werden?
- Ist ein einheitlicher Sollwert ausreichend oder muss eine dynamische Regelung (z.B. Compound-Regelung) für die Spannungsregelung im Umspannwerk eingesetzt werden?
- Wie muss eine dynamische Spannungsregelung aussehen?
- Wann kann ein Netzregler statt eines RONT eingesetzt werden?
- Welche Budgets ergeben sich für konventionelle Ausbaumaßnahmen in die Primärtechnik statt der Investition in Spannungsregler, bzw. RONT?

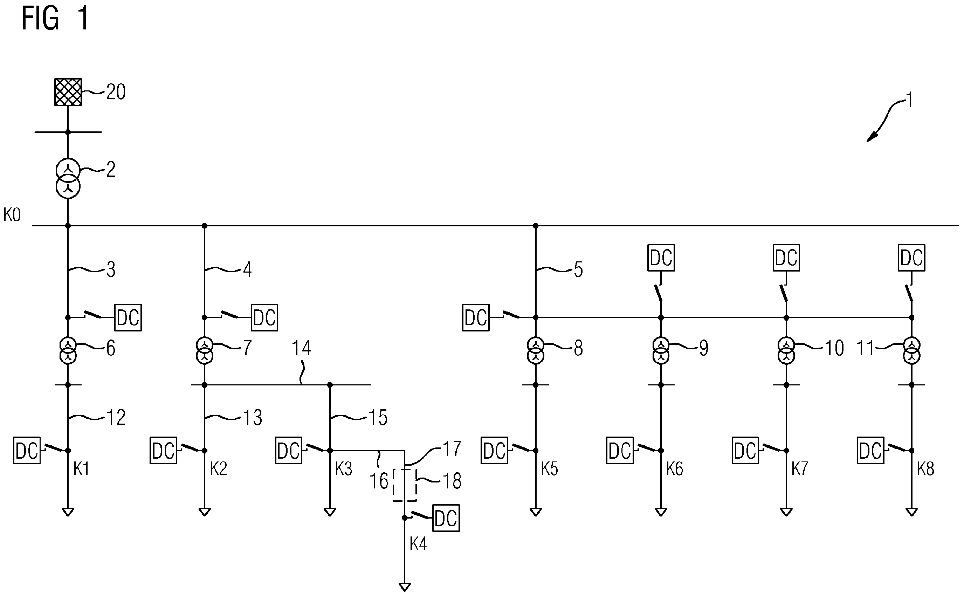

Die folgenden Ausführungen sollen anhand eines Beispiel-Energienetzes (Figur 1) verifiziert werden, das jedoch bereits typische Netzstrukturen enthält.
Das Beispielsnetz 1 ist in der Figur 1 dargestellt und weist folgende typische Verteilungsnetzstrukturen auf:

- Eine Hochspannungsversorgung 20 versorgt über einen Transformator 2 im Umspannwerk eine Mittelspannungsebene K0 mit drei Leitungsstichen 3,4,5.
- Es sind Transformatoren 6 bis 11 zur Versorgung der Niederspannungsebene vorgesehen, die zwar stufenweise geschaltet werden können, aber nicht unter Last (dynamisch) .
- Ein einfacher Leitungsstich 3 mit einem dezentralen Einspeiser DC (z.B. einer Windkraftanlage) in der Mittelspannungsebene und einem Einspeiser DC in der Niederspannungsebene 12 (z.B. einer Photovoltaikanlage).
- Ein zweiter Leitungsstich 4 weist eine Einspeisung DC auf der Mittelspannungsebene auf sowie einen Abzweig 14 auf der Niederspannungsebene, so dass sich zwei Niederspannungsabgänge 13,15 ergeben. Dabei ist der Abgang 16 noch weiter verzweigt und weist einen weiteren Abgang 17 mit einer Position auf, für die im erfindungsgemäßen Verfahren eine regelbare Einrichtung bzw. einem Transformator 18 vorgeschlagen wird.
- Ein dritter Leitungsstich 5 versorgt vier Abzweige mit den Transformatoren 8 bis 11.

Dabei sind jeweils Einspeiseeinrichtungen, die z.B. Photovoltaikanlagen sein können, mit dem Symbol DC gekennzeichnet. Knotenpunke im Mittelspannungsnetz weisen die Kennzeichnung N und eine Zahl auf.

Der dargestellte Transformator 2 sowie die weiteren Transformatoren weisen dabei Einstellungsmöglichkeiten zur Spannungsregelung auf, die so gewählt werden müssen, dass bei unterschiedlichen Einspeisesituationen durch die Einspeiseeinrichtungen DC das vorgegebene Spannungsband von +/- 10 % der Nennspannung auf allen Spannungsebenen eingehalten werden kann.

Das beschriebene Problem kann durch ein unterbestimmtes Gleichungssystem dargestellt werden, dessen Freiheitsgrade zur Optimierung einer zu wählenden Kostenfunktion verwendet werden können. Ein Optimierungsproblem weist immer die drei Bestandteile Variablen, Zielfunktion und Nebenbedingungen auf. Dabei stellen Entscheidungsvariablen zur Errichtung von RONT oder Netzreglern binäre Entscheidungsvariablen, die Regelstufen der Umspanntransformatoren, der ONS, der RONT und der Netzregler ganzzahlige Variablen dar (z.B. Stufen: -2,-1,0,+1,+2). Die Ganzzahligkeitsbedingung kann bei stufenlosen Spannungsreglern entfallen.

Die Ermittlung der sich durch die Stufenstellungen ändernden Knotenspannung ist im allgemeinsten Fall durch eine Lastflussberechnung durchzuführen. Das Lastflussproblem kann durch Nebenbedingungsgleichungen mit den kontinuierlichen Variablen für die Knotenspannungen und Zweigströme formuliert werden. Aufgrund der Nichtlinearität der Lastflussgleichungen ergibt sich durch die erforderliche Linearisierung ein entsprechend hoher Modellierungsaufwand. Weitere Nebenbedingungen ergeben sich aufgrund der Forderung nach Einhaltung der zulässigen Auslastungsgrenzen sowie der Bedingungen zur Spannungsqualität.

Im Rahmen dieser Nebenbedingungen können die Variablen dergestalt ermittelt werden, dass die Zielfunktion optimiert, bzw. im vorliegenden Fall minimiert wird. Die Zielfunktion wird dabei als eine Kostenfunktion formuliert, die die Summe der Investitionsaufwände in RONT und Netzregler sowie die Betriebskosten darstellt.

Die dargestellte Optimierungsaufgabe ist prinzipiell lösbar, auch unter dem Aspekt, dass verschiedene Betriebsfälle des Netzes zu berücksichtigen sind. Allerdings ist der Modellierungsaufwand und der daraus resultierende Berechnungsaufwand enorm - der Aufwand steigt exponentiell mit der Variablenanzahl, so dass für eine praktische Lösung der Aufgabe geeignete Vereinfachungen vor- zunehmen sind. Dies ist beim vorliegenden Problem tatsächlich möglich.

Ziel der Berechnung für das Beispielnetz 1 ist es, die Regelstellungen aller bereits vorhandenen regelbaren Einrichtungen anzugeben und festzustellen, ob an der Position 18 tatsächlich ein RONT oder Netzregler benötigt wird (und dessen Regelstellung).

Hierbei müssen jedoch folgende prinzipielle Annahmen gemacht werden:

1. Es wird davon ausgegangen, dass keine Betriebsmittelüberlastungen auf- treten. In diesem Falle müssen die Zweigströme nicht als Variablen modelliert werden und das Problem kann auf das Spannungsproblem reduziert werden.

2. Spannungsdifferenzen über Zweigelementen sind nur vom Leistungsfluss, nicht von der absoluten Knotenspannung abhängig.

3. Die Lösung muss für alle Betriebsfälle gültig sein.

4. Die Menge der möglichen Betriebsfälle kann implizit durch Auswahl repräsentativer Referenzbetriebsfälle begrenzt werden: Ist die Lösung für diese Betriebsfälle gültig, so ist sie auch für alle anderen Betriebsfälle gültig.

Die erste Annahme führt zu einer bedeutenden Vereinfachung des Problems. Diese ist zulässig, da

- das beschriebene Problem in der Tat ein Spannungsproblem ist: Dies spiegelt sich gerade in den geltenden Richtlinien wider, die auf die Spannungsproblematik fokussieren.
- (n-1)-Versorgungszuverlässigkeit für dezentrale Einspeisungen nicht gefordert ist. Mögliche Überlastungen können z.B. durch Einspeisemanagement gehandhabt werden, so dass zumindest Überlastungen eliminiert werden können. Somit ist die Betrachtung auch nur für den Normalschaltzustand des Netzes durchzuführen.

Die zweite Annahme vernachlässigt die Spannungsabhängigkeit der Last- und Erzeugerströme. Dies korrespondiert näherungsweise mit einem linearen Lastflussproblem, bei dem die Last- und Einspeiseströme konstant sind.

Die vierte Annahme reduziert den Umfang des Optimierungsproblems enorm: Dieses kann prinzipiell für eine beliebige Menge von Betriebszuständen formuliert werden. Von diesen Betriebszuständen sind nun folgende Fälle von besonderer Bedeutung:

a) Betrieb mit maximaler Last und minimaler Einspeiseleistung
b) Betrieb mit minimaler Last und maximaler Einspeiseleistung

Die Korrektheit dieses Ansatzes liegt in der Linearität begründet: Wenn für die ermittelten Optimierungsvariablen die Spannungsbedingungen für diese beiden Betriebsfälle eingehalten werden, werden sie auch für Zwischenzustände eingehalten. Die Extremspannungswerte treten nur bei diesen Betriebsfällen a und b auf.

Der Betrag der Spannung $|Ui^k|$ es Knotens i für den k-ten Betriebsfall ergibt sich aus einem Startwert (Fall 0) und Zusatzspannungsdifferenzen, die hauptsächlich durch die Spannungsregler bedingt sind. Weiterhin wird die Zusatzspannung noch durch stromabhängige Spannungsdifferenzen an den Betriebsmitteln verursacht. Das Lastflussproblem kann somit mit folgendem mathematischen Modell beschrieben werden (Gleichungen 1-3, s. Anhang Mathematische Betrachtung).

Zur Vereinfachung der folgenden Ausführungen wird angenommen, dass die Einspeiseleistungen und Verbraucherlasten reell sind. Für komplexe Leistungen ergibt sich tendenziell die gleiche Aussage. Damit vereinfacht sich die Gleichung (3), wenn zusätzlich ein reelles Übersetzungsverhältnis aufgrund der Längsreglercharakteristik berücksichtigt wird, zu (Gl. 4-8) .

Die erste Summe der Gleichung 8, der Linearisierungsterm, beschreibt die durch die Nichtlinearität bedingten Spannungsdifferenzen zum Wert $|u(0)|$. Bei einheitlichem Konstantleistungscharakter muss der Linearisierungsterm näher analysiert werden. Er kann dabei wiederum in eine Summe mit den differentiellen Koppelwiderständen und einem Term mit dem differentiellen Eigenwiderstand zerlegt werden (Gl. 9).

Die differentiellen Eigen- und Koppelwiderstände können mit Hilfe der Last- flussberechnung direkt ermittelt werden. Die unbekannten Wert $\Delta i(k)$ können wie folgt aus den Knotenspannungen der Knoten m ermittelt werden (Gl 10-13).

Hieraus ergibt sich dann für den Linearisierungsterm (Gl 14,15), so dass die die Spannungsgleichungen folgende Gestalt aufweisen (Gl. 16-18).

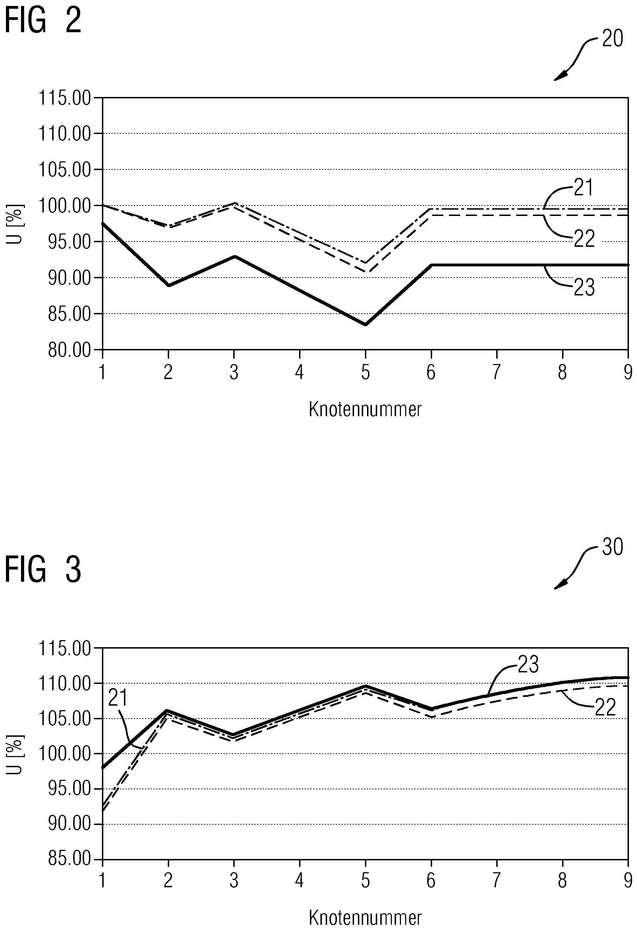

Die beiden Figuren 2 und 3 zeigen die prozentualen Spannungsabweichungen zwischen den gemäß dem linearen Modell 22 berechneten Knotenspannungen und denjenigen Knotenspannungen, die gemäß Netzberechnungsprogramm 21 mit dem Newton-Raphson-Verfahren ermittelt worden sind. Dabei sind auch Knotenspannungen gemäß Anrechenwerten 23 ($|\underline{u}_i^{(0)}|$) dargestellt. Anrechenwerte ergeben sich bei der Simulation bei Beginn der Lösungsfindung, wenn alle Stufenstellungen auf neutral (d.h. 100% Nennspannung an der Ausgangsseite eines Transformators) gesetzt wurden.

Figur 2 zeigt einen Fall für das Beispielnetz mit hoher Last. Die Stufenstellungen wurden nun bereits so gewählt, dass die Spannungen im Korridor +/- 10 % liegen. Die Knotenspannungen, die gemäß Netzberechnungsprogramm 21 berechnet wurden, sind bei einer konstanten Leistung exakt. Der Unterschied der Spannungswerte zwischen den Verfahren 21 und 22 ist sehr gering - dies zeigt, dass der Einsatz eines linearen Modells zur Vereinfachung der Berechnungen für die Erfindung geeignet ist.

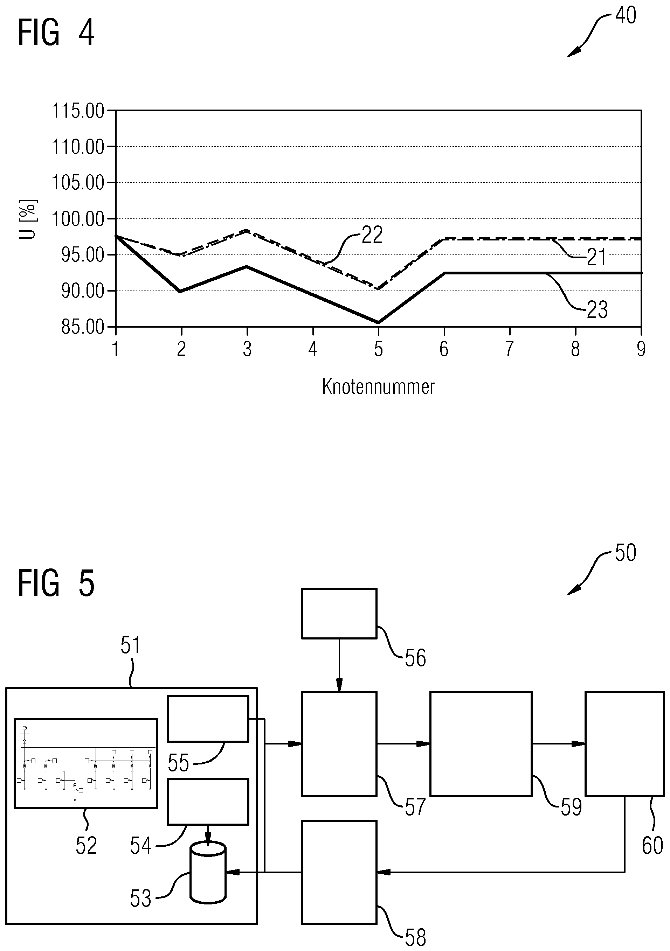

Es zeigt sich, dass bei starker Last (Figur 2) und bei starker Erzeugung (Figur 3) die Abweichungen des Näherungsverfahren systematisch sind: Somit ist zu erwarten, dass bei Anwendung des Linearisierungstermes sich verbesserte Ergebnisse erzielen lassen. Wenn die Knotenströme nicht spannungsabhängig sind (Konstantstromlasten, bzw. Konstantstromeinspeisungen), liefert der Linearisierungsterm keinen Beitrag ($\Delta i = 0$) und muss in diesem Falle nicht betrachtet werden: Für Konstantstromcharakter der Lasten und Einspeisungen können daher für das vereinfachte Modell sehr gute Berechnungsergebnisse erwartet werden (Figur 4). Somit vereinfacht sich das Lastflussproblem zu Gl. 19 und 20.

Dabei beschreibt $r_j^{(k)}$ die Regelstellung des j-ten Regelelementes, $\Delta u_j$ die Zusatzspannung/Regelstufe dieses Reglers und $k_{i,j}$ einen Korrelationsfaktor. In den weiteren Betrachtungen wird das Konstantstrommodell verwendet.

Der Koeffizient $k_{i,j}$ (in Gleichung 20) beschreibt die Korrelation der Spannung am i-ten Knoten mit der Stellung des j-ten Regelelements (Gl. 21). Diese Variable kann entweder topologisch mit einer Breitensuche oder analytisch mit einer Korrelationsanalyse ermittelt werden. Im letzteren Falle ergeben sich die Korrelationskoeffizienten wie in Gl. 23 dargestellt.

Der Wert für $\varepsilon$ sollte etwas kleiner als die kleinste Zusatzspannung/Regelstufe $\Delta u_j$ gewählt werden. Letztendlich kann mit Hilfe dieses Ansatzes ein lineares Gleichungssystem zur Ermittlung der Knotenspannungen in Abhängigkeit der Reglereinstellungen aufgestellt werden. Dieses stellt dann das Lastflussproblem als die Nebenbedingungsgleichungen dar. Die Regelung kann kontinuierlich oder diskret erfolgen. Bei der diskreten Stufung sind die Stufenstellung sowie die Zusatzspannung/Stufe als Nebenbedingungen zu formulieren, z.B. Gl. 23-30.

Die Spannungsbedingungen der EN 50160 können einfach als zusätzliche lineare Nebenbedingungen eingeführt werden: Gl. 31-33. Selbstverständlich müssen die Grenzen unter Umständen auch schärfer gefasst werden, wenn Reserven berücksichtigt werden sollen.

Die Entscheidungsvariablen legen die Notwendigkeit eines RONT oder eines Netzreglers fest. Diese sind binärer Natur. Alle ONS werden als Serienschaltung eines konventionellen ONS mit Stufensteller und eines RONT modelliert. Im Rahmen der Optimierung werden die Variablen $r_j^{(k)}$ für jeden Betriebsfall ermittelt und hieraus die binären Entscheidungsvariablen $b_j$ für einen RONT oder einen Netzregler abgeleitet. Die Bedingungen hierfür lauten für den RONT: Gl. 34-35.

Da der Stufensteller des konventionellen Transformators nicht unter Last schaltbar ist, muss die resultierende Stufenstellung für alle Betriebsfälle gleich sein. Ist dies nicht möglich, so müssen die resultierenden unterschiedlichen Stufenstellungen mit einem RONT realisiert werden.

Die Bedingung für die Erforderlichkeit eines Netzreglers lautet: Gl. 36-37.

Mit Hilfe der so erhaltenen Entscheidungsvariablen kann nun die Zielfunktion formuliert werden (Gl. 38). Die Konstanten C entsprechen dabei den Investitionsaufwänden für einen RONT, bzw. einen Netzregler. Sollten dabei die Kosten für den entsprechenden Regeltransformator nicht einheitlich sein - z.B. aufgrund unterschiedlicher Bemessungsleistungen-, so können auch individuelle Werte für die Kosten angesetzt werden.

Für die Ermittlung der Lösung werden zunächst die Startvektoren der Knotenspannungen $|\underline{u}_i^{(0)}|$ ermittelt. Dies erfolgt mit Hilfe von Lastflussberechnungen für die relevanten Extremfälle bei Neutralstellung aller Spannungsregeleinrichtungen. Dieses "Anrechnen" liefert weitere Nebenbedingungsgleichungen für die Knotenspannungen.

Das so erhaltene Modell stellt ein Optimierungsproblem dar, das durch die Linearisierung des Lastflussproblems mit Hilfe linearer Nebenbedingungen und einer linearen Zielfunktion beschrieben werden. kann. Dabei treten reelle, ganzzahlige und binäre Optimierungsvariablen auf. Eine solche Optimierungsaufgabe kann mit den Methoden der mathematischen Programmierung gelöst werden. Aufgrund der Ganzzahligkeit eines Teils der Variablen ist hier das Verfahren der impliziten Enumeration (Branch & Bound) anzuwenden. Hierbei werden zunächst für einen Teil der Variablen die Ganzzahligkeitsbedingungen aufgegeben und mit Hilfe der Simplex-Methode ein Optimum ermittelt. Ist dieses schlechter als eine bisher gefundene zulässige Lösung, so kann auf eine weitere Untersuchung des entsprechenden "Lösungszweiges" verzichtet werden, ohne die hierzu gehörigen Variablenkombinationen explizit zu untersuchen.

Die Lösung selbst kann mit sogenannten Solvern erfolgen, die die Problemformulierung in normierter Gleichungsform erwarten und die Gleichungen im eigentlichen Optimierungsschritt verarbeiten. Für die folgenden Berechnungen wird der Open-Source-Solver "lp solve" (Michael Berkelaar, lp solve, 2012) eingesetzt. Dieser Solver erreicht zwar gegenüber kommerziell erhältlichen Solvern wie cplex oder Xpress schneller seine Performance-Grenze. Für die in diesem Aufsatz vorgestellte Aufgabenstellung jedoch ist lp solve absolut ausreichend. Die totale Rechenzeit liegt bei den Beispielnetzen im Bereich von 200 ms, so dass auch bei realistischen Netzgrößen und damit einer größeren Variablenanzahl auch mit lp solve eine akzeptable Rechengeschwindigkeit zu erwarten ist.

Alternativ hierzu könnten auch andere Verfahren der globalen Optimierung eingesetzt werden, wie es z.B. in der Netzplanung und im Netzschutz gemacht wurde. Die dort beschriebenen kombinatorisch-heuristischen Verfahren sind dann von Vorteil, wenn die Nichtlinearitäten nicht vernachlässigbar sind, bzw. wenn die Variablenanzahl und der dazugehörige Wertebereich zu groß werden.

Dies wird bei der vorliegenden Aufgabenstellung nicht erwartet. Vielmehr erlaubt gerade die Unabhängigkeit des Lösungsverfahrens von der Aufgabenstellung die einfache Anpassung durch Modifikation der (Un-)Gleichungssysteme, so dass vielfältige Problemstellungen einfach bearbeitet werden können.

In Figur 5 ist der praktische Arbeitsprozess dargestellt. Dabei kommt eine Datenverarbeitungsanordnung 50 zum Einsatz. Die Datenverarbeitungsanordnung 50 weist in diesem Ausführungsbeispiel ein Netzberechnungsprogramm 51, einen Konfigurator 56, einen Modellgenerator 57, einen sog. Mixed-Integer Linear Problems Solver (MILP-Solver) 59 als Berechnungskomponente sowie einen Ergebnis-Interpreter 58 auf.

Mit einem Netzberechnungsprogramm 51 wird ein Netzmodell 52 aufgebaut und ein Lastfluss 54 angerechnet. Weiterhin wird eine Sensitivitätsanalyse 55 ausgeführt. Aus einer Netzdatenbank 53 wird dann mit Hilfe eines Modell-Generators das Gleichungssystem erzeugt und in eine ASCII-Datei geschrieben. Das so aufgestellte Gleichungssystem wird an den Modellgenerator 57 übergeben.

Gegebenenfalls kann die Optimierungsaufgabe im Modellgenerator 57 mit einem Konfigurator 56 durch einen Benutzer angepasst werden: z.B. können Nebenbedingungen geändert werden.

Das Modell wird vom Modellgenerator 57 an den MILP-Solver 59 übergeben, der die Simulation durchrechnet und die Zielfunktion minimiert. Das Ergebnis 60 wird bereit gestellt.

Nach erfolgreicher Lösung wird die Ergebnisdatei, die wiederum in ASCII-Form vorliegt, mittels des Ergebnisinterpreters 58 interpretiert und die entsprechenden Einträge in der Netzdatenbank 53 aktualisiert.

Im Folgenden wird das Ergebnis der Simulation dargestellt.

Für das Beispielnetz gemäß Figur 1 werden nun zwei Betriebsfälle betrachtet:

- Starklastfall: alle dezentralen Einspeisungen werden auf 0 gesetzt. Nur die Lasten werden berücksichtigt.
- Starke Einspeisung: alle Lasten werden auf 0 gesetzt. Die Einspeisung liefern ihre maximale Wirkleistung bei einem Leistungsfaktor $\cos \phi = 1$.
- Die Spannung des Umspannwerksknotens 2 wird lokal geregelt (statische Spannungsregelung). Hierzu wird der Sollwert der Spannung auf einen festen Wert eingestellt - hier auf 102 % der Nennspannung.

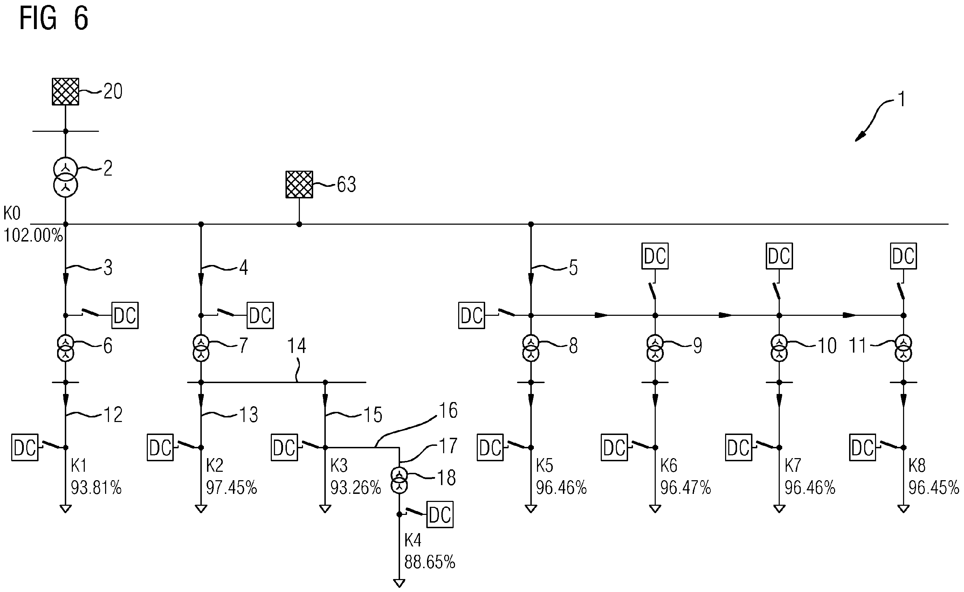

Damit ergeben sich mit einer Lastflussberechnung bei Neutralstellung aller Regler die Knotenspannungen in Figur 6, die jeweils für die Niederspannungsknotenpunkte K1 bis K8 in Prozent der Nennspannung angegeben sind. Im Unterschied zur Figur 1 kommt hier noch eine Spannungseinspeisung 63 hinzu, die dem Beispielnetz der Figur 1 eine Spannung von 102 % der Nennspannung auf der Mittelspannungsebene einprägt. Dies ist ein einfacher Ansatz, um dem Modell eine feste Spannung auf der Ausgangsseite des Transformators 2 vorzugeben.

Man erkennt anhand der Lastflussergebnisse in Figur 6, dass bei maximaler Verbraucherlast sich eine zu niedrige Spannung am Knoten K4 einstellt (88,65 % verletzt das Spannungsband von 90 % bis 110 %).

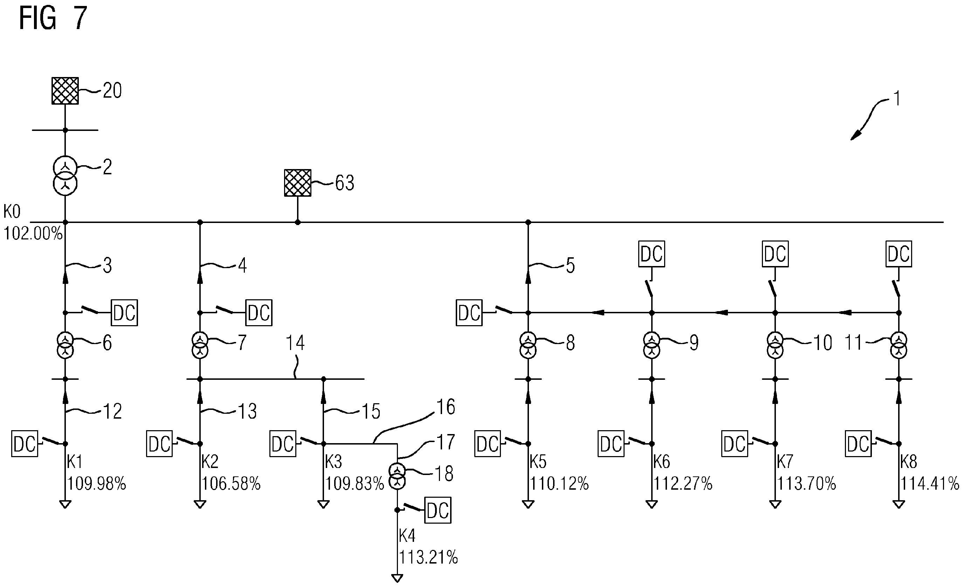

Umgekehrt ergibt sich bei starker Einspeisung in Figur 7 an den Knoten K4, K5, K6, K7 und K8 eine zu hohe Spannung. Hieraus lässt sich bereits ableiten, dass zumindest die Stufenstellungen in den ONS anzupassen sind, um beide Lastfälle abdecken zu können.

Nun soll zunächst folgender Fall untersucht werden: Das Spannungsband wird mit +/- 10 % vorgegeben. Die hierzu erforderlichen Stufenstellungen der konventionellen Transformatoren sollen ermittelt werden. Der Sollwert des Spannungsreglers im Umspannwerk wird im Sinne der statischen Spannungsregelung auf 102 % eingestellt.

Die Ergebnisse der Optimierung sind in Tabelle 1 dargestellt.

| Knoten | Knotenspannung [%] Max. Last | Stufe | Knotenspannung[%] Max. Einspeisung | Stufe |
|---|---|---|---|---|
| 1 | 93,81 | 0 | 102,98 | 0 |
| 2 | 97,45 | 0 | 106,58 | 0 |
| 3 | 93,26 | * | 109,83 | * |
| 4 | 90,65 | −2 | 109,21 | 4 |
| 5 | 93,96 | 1 | 107,62 | 1 |
| 6 | 93,97 | 1 | 109,77 | 1 |
| 7 | 91,46 | 2 | 108,70 | 2 |
| 8 | 91,45 | 2 | 109,41 | 2 |

Tabelle 1

Zunächst soll das Format der Tabelle erläutert werden. Es ergeben sich für jeden der Knoten 1 bis 8 erforderliche Änderungen der Stufenstellung (* : Knoten 3 hat keine unmittelbar vorgeschaltete regelbare Einrichtung, wird jedoch durch die regelbare Einrichtung des Knotens 2 beeinflusst), wobei es für den Starklastfall und den Fall starker Einspeisung im Knoten 4 jeweils einer unterschiedlichen Stufenstellung bedarf. Dies bedeutet, dass dort eine dynamische Regelung erfolgen muss, was ein Hinweis auf den Einbau einer Regeleinrichtung ist. Dabei werden im Beispiel alle ONS-Transformatoren als bauartgleich betrachtet und weisen 5 Stufen von -5 % bis +5 % auf.

Man kann nun aus dem Ergebnis gemäß Tabelle 1 folgende Erkenntnisse ableiten: Die Regelstellungen der Transformatoren 5-8 sind anzupassen. Es ist kein RONT zu installieren. Stattdessen kann im Bereich des Knotens 4 der günstigere Netzregler statt eines RONT installiert werden, denn im Bereich der Leitung 17 handelt es sich um die Niederspannungsebene - es genügt, die Spannung mittels eines Netzreglers um einige Prozent anzupassen. Die resultierenden Gesamtkosten betragen 16000 Euro, wenn das günstigste geeignete Gerät eingebaut wird.

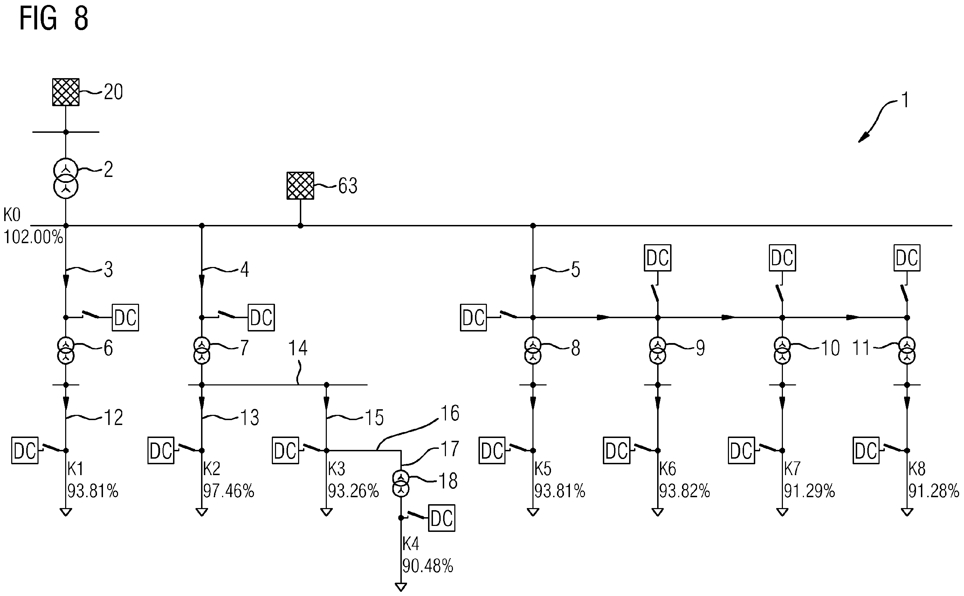

Das Ergebnis der Simulation kann durch Lastflussberechnungen bestätigt werden, deren Lösungen für die Knoten 1 bis 8 in den Figuren 8 (starke Last) und 9 (starke Einspeisung) dargestellt sind.

Nun soll im Bereich des Knotens 2 ein engeres Spannungsband von +/- 5% vorgegeben werden. Hier drängt sich sofort die Frage auf, ob in diesem Falle ein Austausch der Netzstation gegen einen RONT nicht die günstigere Lösung ist. Das Ergebnis der Simulation für diesen Fall zeigt Tabelle 2.

| Kno-ten | Knotenspannung [%] Max. Last | Stufe | Knotenspannung[%] Max. Einspeisung | Stufe |
|---|---|---|---|---|
| 1 | 93,81 | 0 | 109,98 | 0 |
| **2** | **104,45** | **-7** | **99,58** | **7** |
| 3 | 100,26 | * | 102,83 | 0 |
| 4 | 95,65 | 0 | 106,21 | 0 |
| 5 | 93,96 | 0 | 107,62 | 0 |
| 6 | 93,97 | 0 | 109,77 | 0 |
| 7 | 91,46 | 0 | 108,70 | 0 |
| 8 | 91,45 | 0 | 109,41 | 0 |

Tabelle 2

Man erkennt aus dem Ergebnis, dass nun statt eines Netzreglers tatsächlich ein RONT eingesetzt werden muss, um die schärferen Bedingungen einzuhalten. Dadurch erhöht sich der Zielfunktionswert.

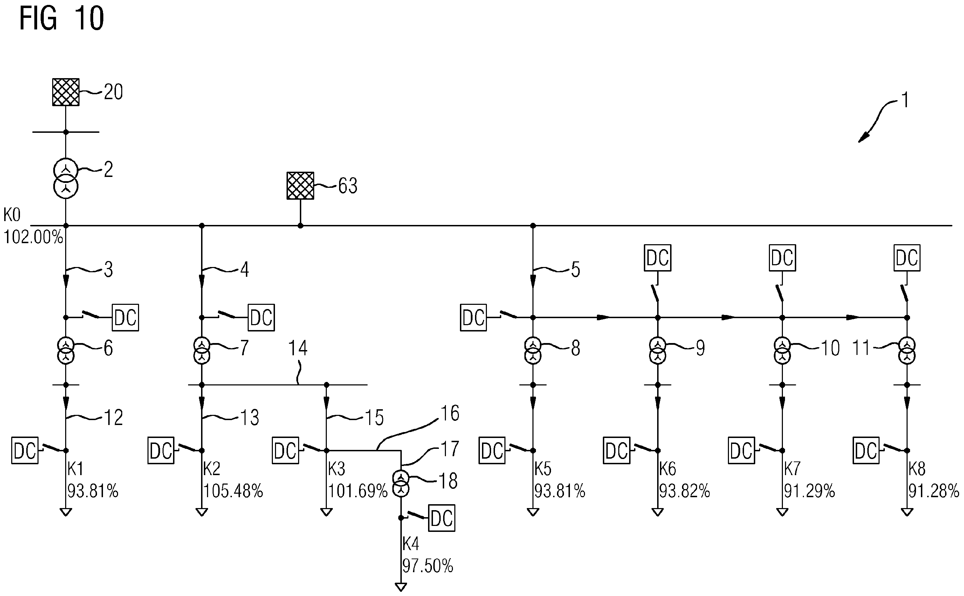

Die Verifikation des Optimierungsergebnisses mit Hilfe von Lastflussberechnungen ist in den Figuren 10 (starke Last) und 11 (starke Einspeisung) dargestellt. Im Bereich des Knotens 2 sind die Linearisierungsfehler etwas stärker als in den übrigen Bereichen. Dies hat jedoch keinen Einfluss auf die letztendliche Entscheidung, dass ein RONT vorgesehen werden muss.

Dieses einfache Beispiel erläutert eine bevorzugte Variante des erfindungsgemäßen Verfahrens.

In einer Weiterbildung können anstatt der dynamischen Spannungsreglung mit Konstantspannungsvorgabe durch einfache Modifikation der Nebenbedingungen auch dynamische Regelungen wie Compound-Regelung oder gar Weitbereichs-Spannungsregelungen (WBR) konzipiert werden. Allerdings sei bereits an dieser Stelle angemerkt, dass bei einer dynamischen Spannungsregelung insbesondere im Umspannwerk nicht mehr garantiert werden kann, dass die Beherrschung der Extremfälle auch gleichzeitig bedeutet, dass Zwischenbetriebsfälle beherrscht werden können. In diesem Falle Ermittlung und entsprechende Beobachtung der kritischen Netzknotenpunkte erforderlich.

Zusammenfassend lässt sich feststellen, dass das erfindungsgemäße Verfahren eine Ermittlung der erforderlichen Spannungs-Regeleinstellungen und Regeleinrichtungen unter Berücksichtigung des wirtschaftlichsten Kapitaleinsatzes ermöglicht. Hierzu werden diejenigen ONS ermittelt, die durch RONT ersetzt werden müssen. Die entsprechenden Kapitalkosten werden berücksichtigt. Dabei kann die Entscheidung auch zugunsten eines Netzreglers fallen, wenn bereits hiermit die Spannungsgrenzen der in dem jeweiligen Teilnetz befindlichen Netzknoten eingehalten werden. Die minimale Anzahl der erforderlichen neuen Regelgeräte wird auch erzielt durch die Einstellung optimaler Stufenstellungen der konventionellen ONS in dem Sinne, dass möglichst wenig zusätzlicher Regelbereich erforderlich ist. Dies ist die Basis der optimalen Einstellung des Spannungsreglers im Umspannwerk. Das beschriebene Verfahren kann im Rahmen der Netzstrukturplanung eingesetzt werden und stellt daher zunächst eine Offline-Methode dar.

In einer ersten Weiterbildung des Ausführungsbeispiels können Linearisierungsfehler vermindert werden.

Die Genauigkeit des Verfahrens hängt von der Volatilität der Knotenspannungen ab. Ändern sich die Knotenspannungen durch die Regelstellung nur in einem begrenzten Bereich, so können die Abweichungen der linearen Berechnung von der genauen nicht-linearen komplexen Berechnung vernachlässigt werden. Bei großen Spannungsdifferenzen zwischen dem Startwert und dem Lösungswert treten aufgrund der Spannungsabhängigkeit der Knotenströme systematische Abweichungen auf, die signifikant, aber noch handhabbar sind. Daher wird bereits in Gleichung 8 ein Korrekturterm eingeführt, der die Reduzierung des Linearisierungsfehlers zum Ziel hat.

Die erste Summe der Gleichung 8, der Linearisierungsterm, beschreibt die durch die Nichtlinearität bedingten Spannungsdifferenzen zum Wert $u_i$. Bei einheitlichem Konstantleistungscharakter muss der Linearisierungsterm näher analysiert werden. Er kann dabei wiederum in eine Summe mit den differentiellen Koppelwiderständen und einem Term mit dem differentiellen Eigenwiderstand zerlegt werden.

In einem ersten Ansatz sollen zunächst die Koppelglieder zu anderen Netzknoten vernachlässigt werden. Dann ergibt sich folgende Vereinfachung gemäß Gl. 39 und 40.

Dabei kann der Betrag der komplexen Scheinleistung statt der Wirkleistung verwendet werden. Dieser Ansatz soll nun für den Lastfall gemäß Tabelle 3 nachvollzogen werden, der sich ohne Anwendung des Linearisierungsterms ergibt (* bezeichnet die Spannung auf der Mittelspannungsebene K0).

**Tabelle 3**

| Knoten | Knotenspannung [%] Max. Last | Stufe | Knotenspannung[%] Max. Einspeisung | Stufe |
|---|---|---|---|---|
| 0* | 91,82 | | 107,61 | |
| 1 | 98,97 | 0 | 100,09 | 0 |
| 2 | 102,83 | 0 | 96,58 | 0 |
| 3 | 98,35 | 0 | 99,93 | 0 |
| 4 | 100,00 | 0 | 100,00 | 0 |
| 5 | 101,77 | 0 | 100,22 | 0 |
| 6 | 99,27 | 0 | 99,95 | 0 |
| 7 | 99,26 | 0 | 101,42 | 0 |
| 8 | 99,25 | 0 | 102,15 | 0 |

Es sollen die Lastflussgleichungen in einem ersten Schritt gemäß Gleichung 39 modelliert werden. Hierzu ergeben sich die Elemente des Linearisierungsterms entsprechend Tabelle 4.

**Tabelle 4**

| Knoten | $u_0$[%] | s[MVA] | Z[$\Omega$] | u0[kV] | r[$\Omega$] | g[S] | r*g | r*g*$u_0$ [%] |
|---|---|---|---|---|---|---|---|---|
| 0* | 97,61 | 20,904 | 1,645 | 19,522 | 1,645 | -0,055 | -0,09 | -8,807 |
| 1 | 88,97 | 0,13 | 0,096 | 0,356 | 0,096 | -1,264 | -0,098 | -8,77 |
| 2 | 92,83 | 0,065 | 0,096 | 0,371 | 0,096 | -0,471 | 0,045 | -4,201 |
| 3 | 88,35 | 0,065 | 0,096 | 0,354 | 0,096 | -0,520 | -0,049 | -4,414 |
| 5 | 91,77 | 0,091 | 0,096 | 0,367 | 0,096 | -0,675 | -0,065 | -5,95 |
| 6 | 91,77 | 0,091 | 0,097 | 0,367 | 0,097 | -0,675 | -0,066 | -6,011 |
| 7 | 91,76 | 0,091 | 0,097 | 0,367 | 0,097 | -0,675 | -0,066 | -6,012 |
| 8 | 91,75 | 0,091 | 0,098 | 0,367 | 0,097 | -0,676 | -0,066 | -6,075 |

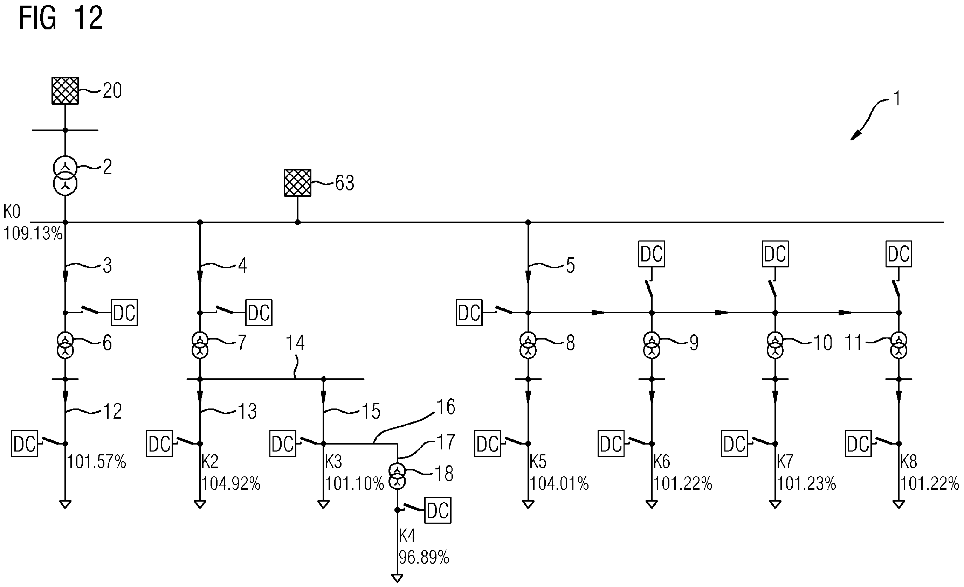

Mit diesem Werten für den Linearisierungsterm werden nun die Spannungsgleichungen erweitert. Dabei werden nun die Regelstellungen der unkorrigierten Berechnung aus Figur 12 entnommen. Bei diesem Beispiel gab es nur einen Netzregler im Netz: der Netzregler, der den Knoten K04 regelt. Unter der Annahme, dass der Netzregler die Spannung die Spannung ausregeln kann, ist die Knotenspannung bekannt (100%) und kann somit bei der Betrachtung vernachlässigt werden. Die numerischen Abweichungen wurden daher nur für die übrigen Knoten im Weiteren betrachtet.

Die Korrektur wird für den Starklastfall (a) vorgenommen. Die Ergebnisse der korrigierten Berechnung sind in Tabelle 5 dargestellt. Man erkennt, dass sich nun alle Knotenspannungen in Richtung höhere Spannung bewegt haben.

**Tabelle 5**

| Knoten | Knotenspannung [%] Max. Last | Stufe | Knotenspannung[%] Max. Einspeisung | Stufe |
|---|---|---|---|---|
| 0* | 91,82 | | 108,64 | |
| 1 | 99,95 | 0 | 100,09 | 0 |
| 2 | 104,34 | 0 | 96,58 | 0 |
| 3 | 99,79 | 0 | 99,93 | 0 |
| 4 | 100,00 | 0 | 100,00 | 0 |
| 5 | 103,51 | 0 | 100,22 | 0 |
| 6 | 100,64 | 0 | 99,95 | 0 |

(fortgesetzt)

| Knoten | Knotenspannung [%] Max. Last | Stufe | Knotenspannung[%] Max. Einspeisung | Stufe |
|---|---|---|---|---|
| 7 | 100,63 | 0 | 101,52 | 0 |
| 8 | 100,69 | 0 | 102,15 | 0 |

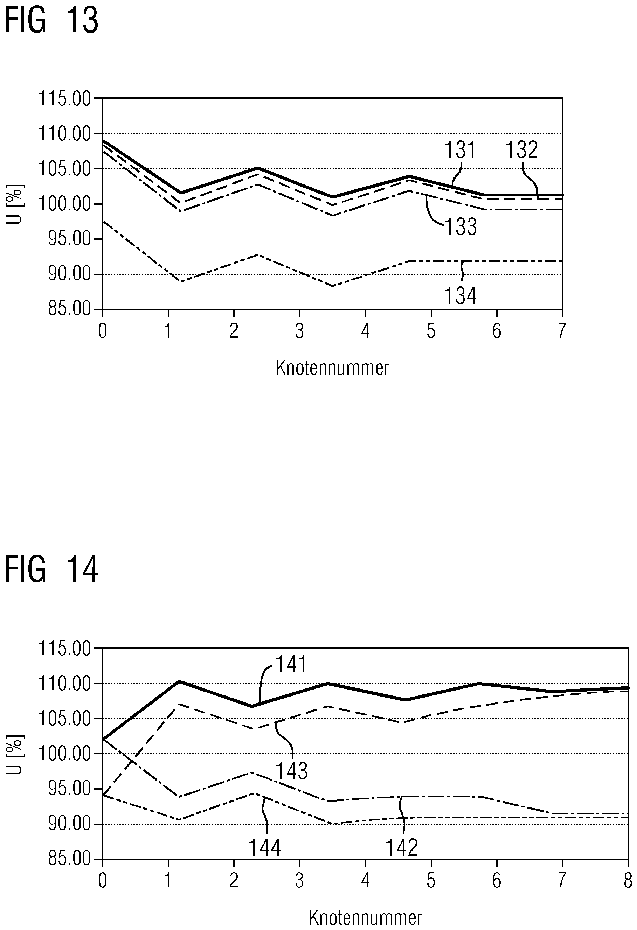

Die korrigierten Spannungswerte haben sich nun signifikant den tatsächlichen Spannungswerten angenähert, wie Figur 13 zeigt. Ausgehend von den Anrechenwerten 134 für die Knotenspannungen ergeben sich die Knotenspannungen mit Korrekturterm für die Linearisierung 132 und ohne Korrekturterm 133, wobei die mathematisch exakte Lösung 131 ebenfalls dargestellt ist. Eine weitere Verbesserung ist noch möglich, wenn die Koppelwiderstände $r_{i,j}$ modelliert werden. Dies wird einen umso positiveren Effekt ergeben, je stärker die Kopplung ist, bzw. je geringer die elektrische Distanz zwischen den Knoten ist. Beim vorliegenden Beispiel erfolgt die Kopplung hauptsächlich über das Mittelspannungsnetz, so dass aufgrund der Transformatorimpedanzen der ONS die einzelnen Koppelwiderstände sehr klein sind. Allerdings treten diese als Summe in der Spannungsgleichung jeder einzelnen Knotenspannung auf und können daher einen signifikanten Einfluss haben. Wird neben der Eigenkopplung auch die Kopplung zu anderen Netzknoten betrachtet, kann das Berechnungsergebnis noch einmal verbessert werden. Allerdings ist darauf zu achten, dass bei einer Berücksichtigung aller möglichen Kopplungen die Spärlichkeit der Spannungsgleichungsmatrix aufgegeben wird: Dies hat deutlichen Einfluss auf die Berechnungsgeschwindigkeit des Solvers. Bei einem typischen radialen Aufbau eines Netzes ergibt sich die Kopplung von Verbrauchern unterschiedlicher Mittelspannungssträng über die Impedanz des Umspannwerkstransformators. Diese Kopplungen werden jedoch bereits über den Eigenterm des Umspannwerksknotens implizit berücksichtigt. Somit brauchen lediglich noch die Koppelterme zu den Netzknoten des gleichen Mittel-, bzw. Niederspannungsstranges berücksichtigt werden und die Spärlichkeit der Spannungsmatrix bleibt weitestgehend erhalten.

In einer zweiten Weiterbildung des Ausführungsbeispiels kann das Verfahren angepasst werden, um als Ergebnis neben der Position auch den benötigten Typ einer regelbaren Einrichtung anzugeben.

Um bei den vorgenannten Beispielen für die Simulation einen Typ eines bestimmten Herstellers als nachzurüstenden RONT angeben zu können, können die Stufenstellung sowie die Zusatzspannung/Stufe als Nebenbedingungen formuliert werden. Dabei ergeben sich z.B. für den Siemens FITformer die Werte gemäß Gleichungen 41 bis 45, für den MR GridCon iTap von MR Reinhausen die Werte gemäß Gleichungen 46 bis 50, für den MRONT Magtech in der Transformatorvariante die Werte gemäß Gleichungen 51 bis 55 und in der Netzreglervariante gemäß Gleichungen 56 bis 58. Für den Netzregler von Walcher ergeben sich die Werte gemäß Gl. 59-61.

Mit diesen Werten kann das Modell gemäß Gleichungen 62-64 erweitert werden. Dabei wird der Regelterm in einen konventionellen Teil und in einen RONT-Teil (Doppelsumme) aufgespalten, wobei der Index s über die verschiedenen Optionen läuft. Dies bedeutet, dass prinzipiell alle optionalen RONT-Möglichkeiten an einem Ort gleichzeitig berücksichtigt werden. Durch die Zielfunktion jedoch wird - wenn überhaupt - nur eine und dann auch nur die kostengünstigste Variante ausgewählt.

Der Optimierung wird dasselbe Netzmodell wie eingangs erläutert zugrunde gelegt. In der dortigen Berechnung hat sich zunächst generell der Einsatz eines Netzreglers beim maximalen Spannungsband als die günstigste Lösung erwiesen. Nun wird untersucht, welcher Regler hier eingesetzt werden soll. Es ergibt sich, dass der Netzregler, der eingesetzt werden muss, in beide Richtungen arbeiten muss (Stufenstellung -1 und 1). Dies leistet der Magtech-Regler nicht und kann daher an dieser Stelle nicht eingesetzt werden.

Nun soll analog zu der damaligen Vorgehensweise das Spannungsband zumindest im Bereich des Knotens 2 enger gefasst werden. In diesem Falle muss ein RONT eingesetzt werden. Dies ist in diesem Falle der GridCon iTap-Regler. Der Netzregler im Abgang zu K4 kann dann entfallen, so dass nur die Investitionsaufwände für den RONT entstehen. Die Lösungen sind für dieses Beispiel zulässig (Details nicht gezeigt), allerdings gibt es signifikante Abweichungen im Bereich des Knotens 2 zwischen der linearen und der iterativen Lastflussberechnung. Dies könnte jedoch mit entsprechender Korrektur unter Zuhilfenahme des Linearisierungsterms verbessert werden.

Nun soll der Fall betrachtet werden, wie eine Lösung mit einem FITformer von Siemens ausgesehen hätte. Die resultierende Zielfunktion setzt sich nun aus den Kosten eines FITformers und den Kosten eines Magtech-Netzreglers zusammen: Da der Regelbereich des FITformers nicht ausreicht, um den Spannungsfall für den Knoten 4 auszugleichen, wird zusätzlich ein Netzregler erforderlich, der weitere Spannungsfälle ausgleichen muss. Da der Magtech-Regler stufenlos verstellbar ist, werden aufgrund des Wegfalls der Ganzzahligkeitsbedingung die Spannungsbedingungen auch genau ausgeregelt. Auch hier muss betont werden, dass mit Hilfe der dynamischen Spannungsregelung zwar die Extremfälle beherrscht werden können. Es ist jedoch nicht sicher gestellt, dass alle Zwischenfälle ebenfalls beherrscht werden können. Hier sind bei heterogener Verbrauchs- und Erzeugungsstruktur entsprechende Knotenspannungen zu überwachen.

In einer dritten Weiterbildung des Ausführungsbeispiels kann das Verfahren angepasst werden, um auch bei ansonsten unverändertem Netz (keine zusätzlichen regelbaren Einrichtungen) eine verbesserte Toleranz für hohe Einspeisungen zu erreichen.

Unter dem EEG-Einspeisemanagement wird eine Netzsicherheitsmaßnahme für Erneuerbare Energien-, Grubengas- und Kernkraftwerks-Anlagen verstanden. Deren bevorrechtigte Einspeisung kann temporär abgeregelt werden, wenn die für den Stromtransport zur Verfügung stehenden Netzkapazitäten nicht ausreichen. Hierbei sind dann den von dem Einspeisemanagement betroffenen Anlagenbetreibern entsprechende Entschädigungszahlungen zu leisten. Diese Entschädigungszahlungen werden über die Netzentgelte gedeckt. Es können dabei zwei Anlässe für die Einleitung des Einspeisemanagements auftreten:

1. Überlastungen von Betriebsmitteln
2. Verletzungen der durch Normen vorgegebenen Spannungsbänder

Im ersten Fall liegen die Maßnahmen des Einspeisemanagements auf der Hand: Die Erzeugerleistung ist z.B. auf dem entsprechenden Netzzweig so zu reduzieren, dass die Überlastung beseitigt wird. Je nach Netzkonfiguration kann jedoch das Spannungsregelkonzept für das Verteilnetz so ausgelegt werden, dass bzgl. der Knotenspannung ein größerer Spielraum hin nach höheren Spannungen gewonnen wird, ohne jedoch die Anforderungen an den Starklastfall zu vernachlässigen. Ein solches Regelkonzept bezieht die dynamische Spannungsregelung im Umspannwerk sowie die stationären Stufenstellerpositionen in den Ortsnetzstationen (ONS) ein. Die vorgeschlagene Methode wird an dem Beispielnetz erläutert.

Im Gegensatz zu dem bisher beschriebenen Ansatz wird das Verfahren nun dazu verwendet, mit minimalem Aufwand, also ohne den Einsatz von RONT's oder Netzreglern, ein Regelkonzept zu entwerfen. Dieses Regelkonzept kommt mit folgenden Maßnahmen auskommt:

1. Ermittlung eines einheitlichen Sollwertes im Umspannwerk im Sinne einer statischen Spannungsregelung.
2. Ermittlung der stationären Stufenstellungen der ONS.

Um dieses Regelkonzept umzusetzen, wird das bisherige Verfahren wird wie folgt modifiziert:

- Der Spannungssollwert im Umspannwerk wird zur Optimierung freigegeben, allerdings muss er für beide Extremfälle (max. Last oder max. Einspeisung) den gleichen Wert aufweisen. Der letztendliche Sollwert kann dann aus dem Startwert beim Anrechnen und der resultierenden Regelstellung des Umspannwerksreglers gewonnen werden.
- Die Zielfunktion wird um Strafterme zur Steuerung der Regelungen erweitert.

Üblicherweise ergibt sich mehr als eine Lösung des Optimierungsproblems. Die Lösungen werden unterschiedliche Regelstellungen aufweisen, ohne die Nebenbedingungen zu verletzen oder die Zielfunktion zu verschlechtern. Dieser Spielraum kann nun genutzt werden, um die resultierenden Spannungswerte der Netzknoten in eine bestimmte Richtung zu zwingen. Möchte man das Netz bei möglichst niedrigen Verlusten betreiben, so ist allgemein ein höheres Spannungsniveau wünschenswert. Soll jedoch ein größerer Spielraum bei der Spannungsreserve im Falle starker Erzeugung gewonnen werden, so sollte sich das allgemeine Spannungsniveau an den unteren Spannungsgrenzen orientieren. Die Steuerung erfolgt durch die Strafterme in der Zielfunktion, wobei eine Abweichung einer Knotenspannung von einem angestrebten Spannungsniveau mit einem Strafterm bewertet (Gleichung 65) wird. Die Strafterme ermitteln sich für alle Knotenspannungen wie folgt (Gl. 66).

Die Strafterme sollten so gewählt werden, dass die übrigen Kostenfaktoren dominant bleiben. Die Investkostenterme können beibehalten werden: Es ist ja gerade das Ziel, eine Regeleinstellung dergestalt zu ändern, dass keine zusätzlichen Regeleinrichtungen erforderlich sind.

In dem verwendeten Beispiel wurde im Unterschied zu dem bisherigen Vorgehen eine Änderung vorgenommen: Die Nebenbedingungen für den Knoten K4 werden hier nicht berücksichtigt, andernfalls würde der Spielraum doch zu sehr eingeschränkt und der angestrebte Effekt würde nicht so deutlich werden. Diese Vernachlässigung stellt jedoch keine wirkliche Einschränkung dar: sie ist äquivalent zu sehen mit einem Netzregler in K4, der sich auch eingangs als günstigste Lösung erwiesen hat.

In der Tabelle 6 sind nun die Regelstellungen der verbleibenden Regeleinrichtungen dargestellt.

**Tabelle 6**

| $U_{soll}$[%] | T0 | T1 | T2 | T5 | T6 | T7 | T8 |
|---|---|---|---|---|---|---|---|
| 90 | 4 | -2 | -2 | -1 | -1 | -1 | -1 |
| 105 | 0 | 0 | 0 | 1 | 1 | 2 | 2 |

Hier erkennt man nun deutliche Unterschiede im Zusammenspiel zwischen Sollwert im Umspannwerk (Knoten K0) und den Stufenstellungen in den einzelnen ONS. Wie Figur 14 zeigt, wird im optimierten Falle der Sollwert auf 94 % = 102 % -4* 2 % eingestellt, während er im Normalfall auf 102 % eingestellt ist. Dies korrespondiert zu den Einstellwerten der Tabelle. Dargestellt sind die Betriebsfälle normale bzw. typische Erzeugungssituation 141, normale bzw. typische Lastsituation 142, als Ergebnis des weitergebildeten Verfahrens optimierte Erzeugungssituation 141 sowie als Ergebnis des weitergebildeten Verfahrens optimierte Lastsituation 143. Man erkennt, dass sich nun die Betriebsspannung in beiden Extremfällen 141,143 in Richtung niedrigerer Spannung entwickelt, ohne jedoch die zulässige untere Grenzspannung von 90 % zu unterschreiten. Die Strafterme werden hierbei nun auf die untere Grenze von 90 % bezogen. Der Unterschied ist signifikant, fällt aber dennoch nicht allzu groß aus: Das Netz selbst weist bereits so extreme Last- und Erzeugungsfälle auf, dass der Spielraum eingeschränkt wird.

Bei besser konditionierten Netzen ergeben sich daher größere Spielräume, die auch bei enger vorgegebenen Spannungsbändern genutzt werden können. Mit diesem Verfahren kann nun auch beurteilt werden, ob der in der Praxis gewählte Sollwert im Umspannwerk auch unter den geänderten Netzbedingungen noch geeignet ist oder ob Potential zur verbeugenden Anpassung vorhanden ist. Dieser Schritt sollte zuerst durchgeführt werden, bevor an erweiterte Strategien der Nahbereichsregelung und der Weitbereichsregelung ergriffen werden. Das beschriebene Verfahren zur Bestimmung der stationären Stufenstellungen von ONS erschließt zusätzliche Spielräume beim Einspeisemanagement. Hiermit können unter dem Aspekt der Spannungsqualität mehr dezentrale Einspeiser angeschlossen werden, ohne dass verstärkte Eingriffe durch das Einspeisemanagement zu erwarten sind. Weiterhin können damit Optimierungspotentiale ausgeschöpft werden, bevor das Spannungsregelkonzept durch alternative Verfahren der NBR (Compound-Regelung) oder der WBR umgesetzt werden müssen.

In einer vierten Weiterbildung des Ausführungsbeispiels kann das Verfahren angepasst werden, um eine Weitbereichs-Spannungsregelung zu ermöglichen.

Die konventionelle Spannungsregelung im Mittelspannungsnetz erfolgt mit Hilfe des Spannungsreglers auf der Oberspannungsseite des Umspanntransformators im Umspannwerk. Im einfachsten Falle wird dabei der Sollwert der unmittelbar an die Sekundärseite angeschlossenen Sammelschiene auf einen festen Wert geregelt. Der Sollwert kann dabei geändert werden, die Änderung erfolgt jedoch in der Regel "von Hand". Bei diesem Verfahren wird davon ausgegangen, dass die höchste Spannung an der Sammelschiene des Umspannwerks auftritt und somit die Spannungen der unterlagerten Mittelspannungs- oder Niederspannungsknoten bezogen auf die jeweilige Nennspannung niedriger sind. Zunächst sollen die verschiedenen Regelstrategien für die Spannung im Umspannwerk beschrieben werden. Der stationären Sollwertvorgabe liegt folgende Heuristik zugrunde: In Abhängigkeit des Blindleistungsflusses über den Transformator ändert sich die sekundäre Spannung. Die Spannungsdifferenz über den Transformator wird über die Regelung auf einen stationären Sollwert ausgeglichen. Die Spannungsdifferenz im Verteilnetz wird durch die Höhe des Sollwertes (z.B. 104 % statt 100 %) ausgeglichen. Dieses Verfahren hat in der Vergangenheit gute Dienste bei ohmsch-induktivem Lastcharakter geleistet. Bei bidirektionalem Lastfluss hingegen stößt es an seine Grenzen.

Um dem Problem des bidirektionalen Lastflusses zu entgegnen, kann der Spannungssollwert dynamisch aus dem Leistungsfluss über den Transformator abgeleitet werden. Diese Strategie einer so genannten Compoundregelung wurde auch in der Vergangenheit im Einzelfalle bei Verbrauchernetzen angewandt, um neben dem Spannungsfall über dem Transformator auch die Spannungsdifferenz im Netz zu reduzieren. Dazu wurde im Starklastfall aus dem Betrag der übertragenen Leistung ein Offset errechnet, um den der Sollwert angehoben werden kann. Dieses Verfahren wurde zur Berücksichtigung des Spannungsanstiegs dahingehend erweitert, dass nun auch die Wirkleistungsrichtung als Indiz für starke Einspeisung verarbeitet wird. Bei Rückspeisung werden dann die Knotenspannungen in den Strangstationen durch dynamisches Absenken des Sollwertes reduziert. Anwendung findet dieses Verfahren z.B. bei E.ON Bayern. Dort wird diesem Verfahren aus Kostengründen der Vorzug gegenüber einer Weitbereichsregelung gegeben, da bei letzterer der Kommunikationsaufwand als größter Nachteil identifiziert worden ist. Dagegen wird unter einer so genannten Nahbereichsregelung die Regelung einer lokal messbaren Spannung verstanden, somit auch die Messung der Spannung im Umspannwerk. Der Sollwert der lokalen Sammelschienenspannung kann dabei unabhängig vom Betriebsfall des Netzes vorgegeben werden oder aus einer sich mit dem Betriebsfall ändernden lokalen Größe.

Diese beiden Konzepte der Nahbereichsregelung und der Compound-Regelung können im Rahmen einer Weitbereichsregelung weiterentwickelt werden.

Die der Compound-Regelung zugrunde liegende Annahme stößt jedoch an ihre Grenzen, wenn das zu versorgende Netzgebiet einen heterogenen Endkundencharakter besitzt: So können in einem Mittelspannungsgebiet durchaus Netzgebiete mit starkem Verbrauchercharakter (z.B. Industriegebiet) als auch Einspeisecharakter auftreten. Je nach Höhe der Rückspeisung kann eine Compound-Regelung zu einer Spannungsabsenkung im Umspannwerk führen, welche dann einen kontraproduktiven Einfluss auf die Netzspannungen in von Verbrauchern dominierten Mittelspannungssträngen haben kann. Weiterhin kann die Compound-Regelung bestenfalls ein tendenzielles Gegensteuern bewirken, die Verletzung der Spannungsbedingungen nach der Norm EN 50160 kann dabei nicht zuverlässig ausgeschlossen werden.

Gerade an diesem Punkt setzt die Strategie der Weitbereichsregelung (WBR) an. Spätestens in diesem Falle muss die Errechnung des Sollwertes einen größeren Netzbereich in die Betrachtung einbeziehen. In diesem Falle spricht man von einer Weitbereichs-Spannungsregelung.

Von dieser Weitbereichs-Spannungsregelung wird erwartet, dass sie mit den größten Beitrag zur Vermeidung von Netzausbaumaßnahmen beitragen kann. Kritische Stimmen hierzu gibt es jedoch auch: Insbesondere die Sicherstellung der Zuordnung der Messstellen zu den zentralen Spannungsreglern wird als Schwachpunkt angeführt, da diese sich aufgrund von Schalthandlungen im Mittelspannungsnetz ändern kann. Weiterhin wird die Problematik der Auswahl der Messstellen angeführt. Beispielsweise werden bisher mit Hilfe von Messungen die Spannungsbänder in ausgesuchten Netzknotenpunkten überwacht und der Sollwert des Umspannwerktransformators so lange verändert, bis die Grenzen eingehalten sind. Die Auswahl der Messstellen erfolgt im Rahmen von Feldmessungen. Erst wenn die Aktivitäten der Spannungsregelung im Umspannwerk an ihre Grenzen stoßen, müssen weitere Schritte wie Blindleistungsregelung oder Einspeisemanagement erfolgen.

Die Verfahren der Compound-Regelung und der Weitbereichsregelung gehören der Gruppe der dynamischen Spannungsregelungen an, da hier die Stufenschalterposition sich in Abhängigkeit des Netzzustandes ändern kann. Dies bedeutet nun, dass statt der stationären Spannungsregelung die Stufenstellung im Umspannwerk je nach Lastfall geändert wird.

Es sind nun in dem Modell alle Entscheidungsvariablen freigegeben und es ergibt sich im Ergebnis der Simulation:

- gegebenenfalls unterschiedliche Regelstellungen des Stufenschalters im Umspannwerk für unterschiedliche Betriebsfälle
- optimierte, aber für die unterschiedlichen Betriebsfälle identische Stufenstellungen für die vorhandenen regelbaren Einrichtungen im Energienetz.

Es soll nun davon ausgegangen werden, dass keine weiteren dynamischen Netzregeleinrichtungen bzw. regelbare Einrichtungen erforderlich sind.

Somit können mit Hilfe der beiden Extremstellungen des Stufenschalters im Umspannwerk alle Betriebsfälle im Netz abgedeckt werden, sofern die Netzstränge eine homogene Struktur aufweisen. Ist dies nicht der Fall, so müssen Kontrollmessungen durchgeführt werden.

Folgende Vorgehensweise wird nun vorgeschlagen:

1. Anrechnen (Ermittlung der Extremlastflüsse)
2. Ermittlung der optimalen Stufenstellerposition in den regelbaren Einrichtungen, z.B den ONS.
3. Einstellung der nun festen Stufenstellungen aus Schritt 2.
4. Erneutes Anrechnen**
5. Ermittlung der optimalen Stufenschalterstellungen im Umspannwerk bzw. Umspannwerktransformator.

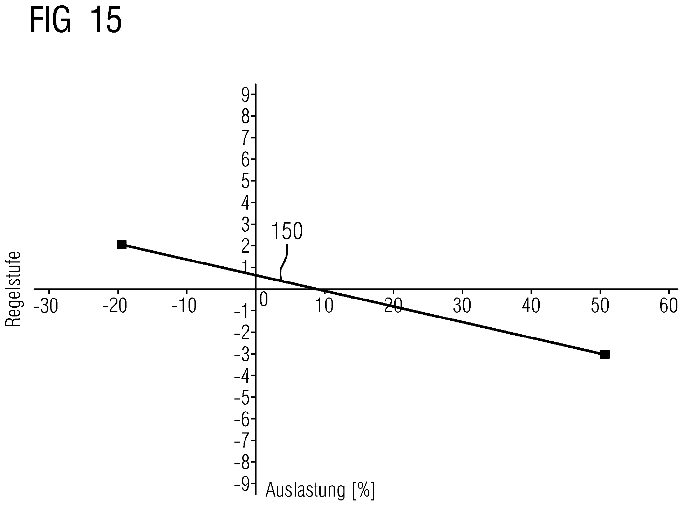

** Der Schritt (4) ist nicht unbedingt erforderlich. Allerdings wird hiermit die Rechengenauigkeit der Spannungsberechnung verbessert und der Ansatz könnte auch im Rahmen eines online-Regelalgorithmus eingesetzt werden. Aus den so ermittelten Extremstellungen für den Stufenschalter im Umspannwerk kann nun die Regelkennlinie 150 gemäß Figur 15 $r_j=f(i_{Transformator})$ ermittelt werden, wobei die Optimierung z.B. einen Stellungswert von 2 bei einer Rückspeisung in der Höhe von 20 % des Transformatornennstromes ermittelt. Bei einer maximalen Last von 50 % für das Maximallastszenario ergäbe sich eine Regelstellung von -3. Dann kann die einfachste Compound-Regelcharakteristik direkt aus dem Diagramm ermittelt werden. Damit kann natürlich nicht das Argument entkräftet werden, dass bei heterogener Kundenstruktur im Netz durch die Compoundierung trotzdem eine Grenzwertverletzung auftreten kann. In diesem Falle ist das Konzept der dynamischen Netzregelung auf eine Weitbereichsregelung mit einer Spannungsüberwachung zu erweitern. Die Strategie zur Weitbereichs-Spannungsregelung ergibt sich aus der allgemeineren Problemstellung fast zwangsläufig, wenn nur noch die Regelstellung des Spannungsreglers des Umspannwerks freigegeben wird und wie oben beschrieben die Stellungen der ONS auf dem optimierten stationären Wert festgehalten werden. Gibt es für den betrachteten Betriebsfall mehr als eine Lösung, so kann mit Hilfe in der dritten Weiterbildung des Ausführungsbeispiels beschriebenen Pönalisierungsmethode die Lösung in die Richtung eines vorgegebenen Spannungskorridors gesteuert werden. Die Entscheidungsvariablen für die RONT bzw. Netzregler haben bei diesem Problem die Aufgabe der Bestrafung von Spannungsbandverletzungen: Können alleine mit der Verstellung des Stufenschalters im Umspannwerk die Spannungsbänder nicht eingehalten werden, so ist die Zielfunktion ungleich Null und es müssen Maßnahmen des Einspeisemanagements ergriffen werden. Die Anzahl der erforderlichen binären Optimierungsvariablen reduziert sich nun deutlich, da für die ONS die Übersetzungsverhältnisse nun fest sind und nur noch die Variablen für die dynamischen Netzregelelemente zu ermitteln sind.

Mit Hilfe der so erhaltenen Entscheidungsvariablen kann nun die Zielfunktion gemäß Gl. 65 und 66 formuliert werden.

Die Zielfunktion nimmt nunmehr den Charakter einer Straffunktion an: Ist hierbei der Investitionsterm ungleich Null (die beiden ersten Summen), so ist die Regelaufgabe nicht alleine mit dem Spannungsregler im Umspannwerk durchführbar und es müssen weitere Maßnahmen ergriffen werden wie die Blindleistungsregelung oder das Einspeisemanagement. Alternativ hierzu können natürlich die Knotenspannungswerte direkt bei Verlassen des zulässigen Spannungsbandes bestraft werden: Dann entfallen auch die Entscheidungsvariablen für die RONT und die Netzregler. Es ergibt sich dann die Problemformulierung gemäß Gleichungen 67-69. Die Wichtungsfaktoren $C_i$ können einheitlich gewählt werden, sollten dabei aber so groß sein, dass keine Störung des Spannungssteuerungsterms $\sum_i p_i$ erfolgt.

Die Genauigkeit dieses Ergebnisses kann verbessert werden, indem die Linearisierungsfehler entsprechend der ersten Weiterbildung des Ausführungsbeispiels korrigiert werden.

Die folgenden vier Seiten zeigen alle Gleichungen, auf die in dieser Anmeldung Bezug genommen wird.

$$|\underline{u}_i^{(k)}| = |\underline{F}_i(\underline{s}^{(k)}, \underline{Z}^{(k)})| \tag{1}$$

$$= |\underline{F}_i(\underline{s}^{(0)}, \underline{Z}^{(0)})| + |\underline{G}_i(\Delta \underline{I}^{(k)}, \bar{\underline{u}}_1^{(k)}, \ldots, \bar{\underline{u}}_m^{(k)})| \tag{2}$$

$$= |\underline{u}_i^{(0)}| + \sum |\underline{G}_{i,j}(\Delta \underline{I}^{(k)}, \bar{\underline{u}}_j^{(k)})| \tag{3}$$

$$|\underline{u}_i^{(k)}| = |\underline{u}_i^{(0)}| + \sum_j |\underline{G}_{i,j}(\underline{I}^{(k)}, \bar{\underline{u}}_j^{(k)})| \tag{4}$$

$$= |\underline{u}_i^{(0)}| + \sum_j G_{i,j}(\underline{I}^{(k)}, \bar{\underline{u}}_j^{(k)}) \tag{5}$$

$$= |\underline{u}_i^{(0)}| + \sum_m \Delta U_i(i_m^{(k)}) + \sum_j V_{i,j}(\bar{\underline{u}}_j^{(k)}) \tag{6}$$

$$= |\underline{u}_i^{(0)}| + \sum_m \Delta U_i(i_m^{(k)}) + \sum_j v_{i,j}\bar{u}_j^{(k)} \tag{7}$$

$$= |\underline{u}_i^{(0)}| + \sum_m \frac{\delta U_i}{\delta i_m^{(k)}} \Delta i_m^{(k)} + \sum_j v_{i,j}\bar{u}_j^{(k)} \tag{8}$$

$$\sum_m \frac{\delta U_i}{\delta i_m^{(k)}} \Delta i_m^{(k)} = \sum_{m \neq i} \frac{\delta U_i}{\delta i_m^{(k)}} \Delta i_m^{(k)} + \frac{\delta U_i}{\delta i_i^{(k)}} \Delta i_i^{(k)} \tag{9}$$

$$i = \frac{P}{u} \tag{10}$$

$$di = \frac{\delta i}{\delta P} dP + \frac{\delta i}{\delta u} du \tag{11}$$

$$= \frac{\delta i}{\delta u} du \tag{12}$$

$$= -\frac{P}{u_0^2} du \tag{13}$$

$$\sum_m \frac{\delta U_i}{\delta i_m^{(k)}} \Delta i_m^{(k)} = \sum_m \frac{\delta U_i}{\delta i_m^{(k)}} \frac{-P_m}{u_m^{(0)^2}} \Delta u_m^{(k)} \tag{14}$$

$$= \sum_m r_{i,m} g_m \Delta u_m^{(k)} \tag{15}$$

$$|\underline{u}_i^{(k)}| = |\underline{u}_i^{(0)}| + \sum_m \frac{\delta U_i}{\delta i_m^{(k)}} \triangle i_m^{(k)} + \sum_j v_{i,j} \tilde{u}_j^{(k)} \tag{16}$$

$$= |\underline{u}_i^{(0)}| + \sum_m r_{i,m} g_m \triangle u_m^{(k)} + \sum_j v_{i,j} \tilde{u}_j^{(k)} \tag{17}$$

$$= |\underline{u}_i^{(0)}| + \sum_m r_{i,m} g_m (|\underline{u}_m^{(k)}| - |\underline{u}_m^{(0)}|) + \sum_j v_{i,j} \tilde{u}_j^{(k)} \tag{18}$$

$$|\underline{u}_i^{(k)}| = |\underline{u}_i^{(0)}| + \sum_j v_{i,j} \tilde{u}_j^{(k)} \tag{19}$$

$$= |\underline{u}_i^{(0)}| + \sum_j k_{i,j} r_j^{(k)} \triangle u_j \tag{20}$$

$$k_{i,j} \epsilon [0,1] \tag{21}$$

$$k_{i,j} = \begin{cases} 0 & \text{für } \frac{|u_i^{(r_j \neq 0)}| - |\underline{u}_i^{(r_j=0)}|}{\triangle u_j} \leq \epsilon \\ 1 & \text{für } \frac{|u_i^{(r_j \neq 0)}| - |\underline{u}_i^{(r_j=0)}|}{\triangle u_j} > \epsilon \end{cases} \tag{22}$$

$$UW - \text{Transformator } \triangle u_i = 2\% \tag{23}$$

$$r_j^{(k)} \quad \epsilon \quad |-9,\dots,0,\dots 9| \tag{24}$$

$$ONS \triangle u_i = 2,5\% \tag{25}$$

$$r_j \quad \epsilon \quad |-2,-1,0,1,2| \tag{26}$$

$$RONT \triangle u_i = 1\% \tag{27}$$

$$r_j^{(k)} = |0,1,\dots,7| \tag{28}$$

$$\text{Netzregler } \triangle u_i = 1\% \tag{29}$$

$$r_j^{(k)} = |-4,\dots,0,\dots,4| \tag{30}$$

$$u_i^{(k)} \leq 110 \tag{31}$$

$$u_i^{(k)} \geq 90 \tag{32}$$

$$\tag{33}$$

$$b_{RONT,j} \quad \epsilon \quad [0,1] \tag{34}$$

$$b_{RONT,j} \;=\; \left\{ \begin{array}{ll} 1 & r_j^{(k)} \neq r_j^{(l)}, l \neq k \\ 0 & r_j^{(k)} = r_j^{(l)}, l \neq k \end{array} \right\} \tag{35}$$

$$b_{NR,j} \quad \epsilon \quad [0,1] \tag{36}$$

$$b_{NR,j} \;=\; 1 \; und \; r_j \neq 0 \tag{37}$$

$$O = \mathrm{Min}\left( \sum_j b_{RONT,j} C_{RONT,j} + \sum_j b_{NR,j} C_{NR,j} \right) \tag{38}$$

$$|\underline{u}_i^{(k)}| \;=\; |\underline{u}_i^{(0)}| + r_{i,1} g_i (|\underline{u}_m^{(k)}| - |\underline{u}_i^{(0)}|) + \sum_j n_{i,j} \bar{u}_j^{(k)} \tag{39}$$

$$g_i \;=\; \frac{-s_i}{u_0^2} \tag{40}$$

$$OS \triangle u_i \;=\; 2,5\% \tag{41}$$

$$r_j^{(l)} = r_j^{(k)} \quad \epsilon \quad [-2,-1,0,1,2] \tag{42}$$

$$US \triangle u_i \;=\; 3,57\% \tag{43}$$

$$r_j^{(k)} \;=\; [-1,0,1] \tag{44}$$

$$C_{RONT,j} \;=\; 22000 \tag{45}$$

$$OS \triangle u_i \;=\; 2,5\% \tag{46}$$

$$r_j^{(l)} = r_j^{(k)} \quad \epsilon \quad [-2,-1,0,1,2] \tag{47}$$

$$OS, RONT \triangle u_i \;=\; 2,5\% \tag{48}$$

$$r_j^{(k)} + r_j^{(l)} \;=\; [-4,...,0,...,4] \tag{49}$$

$$C_{RONT,j} \;=\; 25000 \tag{50}$$

$$OS \, \triangle u_i \;\; = \;\; 2,5\% \tag{51}$$

$$r_j^{(l)} = r_j^{(k)} \quad \varepsilon \quad [-2,-1,0,1,2] \tag{52}$$

$$US \, \triangle u_i \;\; = \;\; 1\% \tag{53}$$

$$r_j^{(k)} \;\; = \;\; [0..7] \tag{54}$$

$$C_{RONT,j} \;\; = \;\; 25000(\text{angenommen}) \tag{55}$$

Für die Netweglervariante ergibt sich:

$$US \, \triangle u_i \;\; = \;\; 1\% \tag{56}$$

$$r_j^{(k)} \;\; = \;\; [0..7] \tag{57}$$

$$C_{NR,j} \;\; = \;\; 15000(\text{angenommen}) \tag{58}$$

$$US \, \triangle u_i \;\; = \;\; 2,6\% \tag{59}$$

$$r_j^{(k)} \;\; = \;\; [-6,...,0,...,6] \tag{60}$$

$$C_{NR,j} \;\; = \;\; 16000 \tag{61}$$

$$|\underline{u}_i^{(k)}| \;\; = \;\; |\underline{u}_i^{(0)}| + \sum_j v_{i,j} \bar{u}_j^{(k)} \tag{62}$$

$$= \;\; |\underline{u}_i^{(0)}| + \sum_j k_{i,j} r_j^{(k)} \triangle u_j \tag{63}$$

$$= \;\; |\underline{u}_i^{(0)}| + \sum_j k_{i,j} r_j^{(k)} \triangle u_j + \sum_s \sum_j k_{i,j} r_{j,s}^{(k)} \triangle u_{j,s} \tag{64}$$

$$O = \text{Min} \left( \sum_j b_{RONT,j} C_{RONT,j} + \sum_j b_{NR,j} C_{NR,j} + \sum_i p_i \right) \tag{65}$$

$$p_i = | |\underline{u}_i^{(k)}| - u_{soll} | \tag{66}$$

$$O \;\; = \;\; \text{Min} \left( \sum_i q_i + \sum_i p_i \right) \tag{67}$$

$$p_i = \left| |\underline{u}_q^{(k)}| - u_{soll} \right| \tag{68}$$

$$q_i = \left\{ \begin{array}{ll} 0 & 90 \leq |\underline{u}_q^{(k)}| \leq 110 \\ C_i & \text{sonst} \end{array} \right\} \tag{69}$$

**Patentansprüche**

1. Verfahren zur Nachrüstung eines bestehenden elektrischen Energienetzes (1,61,81,82,83,84,85) mit zusätzlichen regelbaren Einrichtungen zur Energieübertragung,

   - bei dem ein Modell (52) des Energienetzes bereitgestellt wird, das eine Spannungsverteilung innerhalb des Energienetzes mittels eines Gleichungssystems und/oder Ungleichungssystems in Abhängigkeit von Anzahl und Position von zusätzlichen regelbaren Einrichtungen sowie von Regelstellungen aller regelbaren Einrichtungen berücksichtigt, und
   - bei dem anhand des Modells (52) eine Simulation zur Minimierung einer Zielfunktion durchgeführt wird, wobei die Zielfunktion Nachrüstungsaufwände und/oder Energieverluste durch die zusätzlichen regelbaren Einrichtungen berücksichtigt, und
   - bei dem als Ergebnis (60) der Simulation die Anzahl und Position von zusätzlich benötigten regelbaren Einrichtungen sowie die Regelstellungen aller regelbaren Einrichtungen angegeben werden, damit das Energienetz (1,61,81,82,83,84,85) im Betrieb ein vorgegebenes Spannungsband einhält, **dadurch gekennzeichnet, dass** die Zielfunktion mittels einer
   gemischt-ganzzahligen Optimierung minimiert wird,
   wobei für das Einhalten des vorgegebenen Spannungsbandes ein Betrieb des Energienetzes

   a) mit maximaler Last und minimaler Einspeiseleistung, und
   b) mit minimaler Last und maximaler Einspeiseleistung simuliert wird.

2. Verfahren nach Anspruch 1, **dadurch gekennzeichnet, dass** das Ergebnis (60) verwendet wird, um an der angegebenen Position im Energienetz die zusätzlich benötigten regelbaren Einrichtungen nachzurüsten.

3. Verfahren nach Anspruch 1 oder 2, **dadurch gekennzeichnet, dass** als regelbare Einrichtungen ein Umspannwerktransformator (2, 64) mit regelbarer Ausgangsspannung und/oder stufenweise-regelbare Ortsnetztransformatoren und/oder stufenlos-regelbare Ortsnetztransformatoren und/oder Netzregler verwendet werden.

4. Verfahren nach einem der vorhergehenden Ansprüche, **dadurch gekennzeichnet, dass** das vorgegebene Spannungsband +/- 10% einer vorgegebenen Nennspannung des Energienetzes beträgt.

5. Verfahren nach Anspruch 4, **dadurch gekennzeichnet, dass** als gemischt-ganzzahlige Optimierung ein Branch&Bound-Verfahren verwendet wird.

6. Verfahren nach einem der vorhergehenden Ansprüche, **dadurch gekennzeichnet, dass** als Ergebnis für jede zusätzliche regelbare Einrichtung ein spezifischer Typ der Einrichtung eines spezifischen Herstellers angegeben wird.

7. Datenverarbeitungsanordnung (50) zur Nachrüstung eines bestehenden elektrischen Energienetzes mit zusätzlichen regelbaren Einrichtungen zur Energieübertragung,

   - mit einer Modelleinrichtung, die dazu ausgelegt ist, ein Modell des Energienetzes bereit zu stellen, das eine Spannungsverteilung innerhalb des Energienetzes mittels eines Gleichungssystems und/oder Ungleichungssystems in Abhängigkeit von Anzahl und Position von benötigten zusätzlichen regelbaren Einrichtungen sowie von Regelstellungen aller regelbaren Einrichtungen berücksichtigt, und
   - mit einer Simulationseinrichtung, die dazu ausgelegt ist, anhand des Modells eine Simulation zur Minimierung einer Zielfunktion durchzuführen, wobei die Zielfunktion Nachrüstungsaufwände und/oder Energieverluste durch die zusätzlichen regelbaren Einrichtungen berücksichtigt,

- wobei als Ergebnis der Simulation die Anzahl und Position von zusätzlich benötigten regelbaren Einrichtungen sowie die Regelstellungen aller regelbaren Einrichtungen angegeben werden, damit das Energienetz im Betrieb ein vorgegebenes Spannungsband einhält,

**dadurch gekennzeichnet, dass**

die Simulationseinrichtung ausgebildet ist, die Zielfunktion mittels einer gemischt-ganzzahligen Optimierung zu minimieren, und für das Einhalten des vorgegebenen Spannungsbandes ein Betrieb des Energienetzes

a) mit maximaler Last und minimaler Einspeiseleistung, und
b) mit minimaler Last und maximaler Einspeiseleistung zu simulieren.

8. Datenverarbeitungsanordnung nach Anspruch 7, **dadurch gekennzeichnet, dass** die Datenverarbeitungsanordnung so ausgelegt ist, dass das Ergebnis verwendbar ist, um an der angegebenen Position im Energienetz die zusätzlich benötigten regelbaren Einrichtungen nachzurüsten.

9. Datenverarbeitungsanordnung nach Anspruch 8, **dadurch gekennzeichnet, dass** die regelbaren Einrichtungen einen Umspannwerktransformator (2,64) mit regelbarer Ausgangsspannung und/oder stufenweise-regelbare Ortsnetztransformatoren und/oder stufenlos-regelbare Ortsnetztransformatoren und/oder Netzregler umfassen.

10. Datenverarbeitungsanordnung nach Anspruch 8 oder 9, **dadurch gekennzeichnet, dass** das vorgegebene Spannungsband +/- 10% einer vorgegebenen Nennspannung des Energienetzes beträgt.

11. Datenverarbeitungsanordnung nach einem der Ansprüche 8 bis 10, **dadurch gekennzeichnet, dass** die Simulationseinrichtung eingerichtet ist, als Ergebnis zusätzlich für jede regelbare Einrichtung einen spezifischen Typ der Einrichtung eines spezifischen Herstellers anzugeben.

12. Computerprogrammprodukt, das in einem computerlesbaren Medium gespeichert ist und computerlesbare Programmmittel umfasst, mittels derer ein Computer als Datenverarbeitungsanordnung und/oder eine Server-basierte Datenverarbeitungsanordnung veranlasst werden, ein Verfahren nach einem der Ansprüche 1 bis 6 durchzuführen, wenn die Programmmittel auf dem Computer und/oder der Server-basierten Datenverarbeitungsanordnung ausgeführt werden.

**Claims**

1. Method for retrofitting an existing electrical energy network (1, 61, 81, 82, 83, 84, 85) with additional controllable devices for transmitting energy,

- in which a model (52) of the energy network is provided, which model takes into account a voltage distribution inside the energy network by means of a system of equations and/or a system of inequations on the basis of the number and position of additional controllable devices and on the basis of control positions of all controllable devices, and
- in which the model (52) is used to carry out a simulation for minimizing a target function, the target function taking into account retrofitting effort and/or energy losses caused by the additional controllable devices, and
- in which the number and position of additionally required controllable devices and the control positions of all controllable devices are stated as the result (60) of the simulation so that the energy network (1, 61, 81, 82, 83, 84, 85) complies with a predefined voltage band during operation, **characterized in that**
the target function is minimized by means of mixed-integer optimization, wherein, in order to comply with the predefined voltage band, operation of the energy network

a) with maximum load and minimum feed-in power, and
b) with minimum load and maximum feed-in power

is simulated.

2. Method according to Claim 1, **characterized in that** the result (60) is used to retrofit the additionally required controllable devices at the stated position in the energy network.

3. Method according to Claim 1 or 2, **characterized in that** a substation transformer (2, 64) with a controllable output voltage and/or local network transformers which can be controlled in a stepwise manner and/or local network transformers which can be controlled in an infinitely variable manner and/or network controllers are used as controllable devices.

4. Method according to one of the preceding claims, **characterized in that** the predefined voltage band is +/-10% of a predefined nominal voltage of the energy network.

5. Method according to Claim 4, **characterized in that** a branch & bound method is used as the mixed-integer optimization.

6. Method according to one of the preceding claims, **characterized in that** a specific type of device from a specific manufacturer is stated as the result for each additional controllable device.

7. Data processing arrangement (50) for retrofitting an existing electrical energy network with additional controllable devices for transmitting energy,

- having a model device which is designed for providing a model of the energy network, which model takes into account a voltage distribution inside the energy network by means of a system of equations and/or a system of inequations on the basis of the number and position of required additional controllable devices and on the basis of control positions of all controllable devices, and
- having a simulation device which is designed for using the model to carry out a simulation for minimizing a target function, the target function taking into account retrofitting effort and/or energy losses caused by the additional controllable devices,
- the number and position of additionally required controllable devices and the control positions of all controllable devices being stated as the result of the simulation so that the energy network complies with a predefined voltage band during operation,
**characterized in that** the simulation device is designed to minimize the target function by means of mixed-integer optimization and,
in order to comply with the predefined voltage band, to simulate operation of the energy network

a) with maximum load and minimum feed-in power, and
b) with minimum load and maximum feed-in power.

8. Data processing arrangement according to Claim 7, **characterized in that** the data processing arrangement is designed such that the result can be used to retrofit the additionally required controllable devices at the stated position in the energy network.

9. Data processing arrangement according to Claim 8, **characterized in that** the controllable devices comprise a substation transformer (2, 64) with a controllable output voltage and/or local network transformers which can be controlled in a stepwise manner and/or local network transformers which can be controlled in an infinitely variable manner and/or network controllers.

10. Data processing arrangement according to Claim 8 or 9, **characterized in that** the predefined voltage band is +/-10% of a predefined nominal voltage of the energy network.

11. Data processing arrangement according to one of Claims 8 to 10, **characterized in that** the simulation device is set up to additionally state a specific type of device from a specific manufacturer as the result for each controllable device.

12. Computer program product which is stored in a computer-readable medium and comprises computer-readable program means which cause a computer as the data processing arrangement and/or a server-based data processing arrangement to carry out a method according to one of Claims 1 to 6 when the program means are executed on the computer and/or the server-based data processing arrangement.

**Revendications**

1. Procédé de mise à niveau d'un réseau (1, 61, 81, 82, 83, 84, 85) d'énergie électrique existant par des dispositifs réglables supplémentaires pour le transport d'énergie,

- dans lequel on se procure un modèle (52) du réseau d'énergie, qui prend en compte une répartition des tensions au sein du réseau d'énergie, au moyen d'un système d'équations et/ou d'un système d'inéquations, en fonction du nombre et de la position de dispositifs réglables supplémentaires ainsi que de positions de réglage de tous les dispositifs réglables et

- dans lequel, à l'aide du modèle (52), on effectue une simulation pour minimiser une fonction cible, la fonction cible prenant en compte des dépenses de mise à niveau et/ou des pertes d'énergie par les dispositifs réglables supplémentaires et

- dans lequel on indique, comme résultat (60) de la simulation, le nombre et la position de dispositifs réglables nécessaires supplémentairement, ainsi que les positions de réglage de tous les dispositifs réglables, afin que le réseau (1, 61, 81, 82, 83, 84, 85) d'énergie tienne en fonctionnement une bande de tension donnée à l'avance, **caractérisé en ce que**

on minimise la fonction cible au moyen d'une optimisation mélangée-en nombre entier,

dans lequel, pour tenir la bande de tension donnée à l'avance, on simule un fonctionnement du réseau d'énergie

a) à charge maximum et à puissance injectée minimum et
b) à charge minimum et à puissance injectée maximum.

2. Procédé suivant la revendication 1, **caractérisé en ce que** l'on utilise le résultat (60) pour, à la position indiquée dans le réseau d'énergie, mettre à niveau les dispositifs réglables nécessaires supplémentairement.

3. Procédé suivant la revendication 1 ou 2, **caractérisé en ce que** l'on utilise, comme dispositif réglable, un transformateur (2, 64) de sous-centrale à tension de sortie réglable et/ou des transformateurs de réseau locaux réglables par degré et/ou des transformateurs de réseau locaux réglables en continu et/ou des régleurs de réseau.

4. Procédé suivant l'une des revendications précédentes, **caractérisé en ce que** la bande de tension donnée à l'avance représente +/- 10% d'une tension nominale donnée à l'avance du réseau d'énergie.

5. Procédé suivant la revendication 4, **caractérisé en ce que** l'on utilise, comme optimisation mélangée-en nombre entier, un procédé Branch&Bound.

6. Procédé suivant l'une des revendications précédentes, **caractérisé en ce que** l'on indique, comme résultat, pour chaque dispositif réglable supplémentaire, un type précis de dispositif d'un fabricant précis.

7. Système (50) de traitement de données pour la mise à niveau d'un réseau d'énergie électrique existant par des dispositifs réglables supplémentaires pour le transport d'énergie,

- comprenant un dispositif de modélisation conçu pour mettre à disposition un modèle du réseau d'énergie, qui prend en compte une répartition de tension au sein du réseau d'énergie au moyen d'un système d'équations et/ou d'un système d'inéquations, en fonction du nombre et de la position de dispositifs réglables supplémentaires nécessaires, ainsi que de positions de réglage de tous les dispositifs réglables et

- comprenant un dispositif de simulation, qui est conçu pour effectuer, à l'aide du modèle, une simulation pour minimiser une fonction cible, la fonction cible prenant en compte des dépenses de mise à niveau et/ou des pertes d'énergie par les dispositifs réglables supplémentaires,

- dans lequel on indique, comme résultat de la simulation, le nombre et la position de dispositifs réglables nécessaires supplémentairement, ainsi que les positions de réglage de tous les dispositifs réglables, afin que le réseau d'énergie tienne en fonctionnement une bande de tension donnée à l'avance, **caractérisé en ce que** le dispositif de simulation est constitué pour minimiser la fonction cible au moyen d'une optimisation mélangée-en nombre entier,

et pour le respect de la bande de tension donnée à l'avance, pour simuler un fonctionnement du réseau d'énergie

a) à charge maximum et à puissance injectée minimum et
b) à charge minimum et à puissance injectée maximum.

8. Système de traitement de données suivant la revendication 7, **caractérisé en ce que** le système de traitement de données est conçu de manière à pouvoir utiliser le résultat, afin de mettre, à la position indiquée dans le réseau d'énergie, les dispositifs réglables nécessaires supplémentairement.

9.  Système de traitement de données suivant la revendication 8, **caractérisé en ce que** les dispositifs réglables comprennent un transformateur (2, 64) de sous-centrale à tension de sortie réglable et/ou des transformateurs de réseau locaux réglables par degré et/ou des transformateurs de réseau locaux réglables en continu et/ou des régleurs de réseau.

10. Système de traitement de données suivant la revendication 8 ou 9, **caractérisé en ce que** la bande de tension donnée à l'avance représente +/- 10% d'une tension nominale donnée à l'avance du réseau d'énergie.

11. Système de traitement de données suivant l'une des revendications 8 à 10, **caractérisé en ce que** le dispositif de simulation est conçu pour indiquer, comme résultat supplémentairement pour chaque dispositif réglable, un type précis de dispositif d'un fabricant précis.

12. Produit de programme d'ordinateur, qui est mémorisé dans un support déchiffrable par ordinateur et qui comprend des moyens de programme déchiffrables par ordinateur au moyen desquels un ordinateur, comme système de traitement de données, et/ou un système de traitement de données reposant sur un serveur font qu'un procédé suivant l'une des revendications 1 à 6 est effectué, lorsque les moyens de programme sont réalisés sur l'ordinateur et/ou sur le système de traitement de données.

FIG 1

EP 3 125 397 B1

## FIG 2

## FIG 3

FIG 4

~40

FIG 5

~50

FIG 6

EP 3 125 397 B1

FIG 7

EP 3 125 397 B1

FIG 8

EP 3 125 397 B1

FIG 9

EP 3 125 397 B1

FIG 10

EP 3 125 397 B1

FIG 11

EP 3 125 397 B1

FIG 12

EP 3 125 397 B1

## FIG 13

## FIG 14

FIG 15

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2012037989 A1
- WO 20100357516 A1
- WO 2014152408 A2
- US 2015088439 A1
- US 2009276170 A1

**In der Beschreibung aufgeführte Nicht-Patentliteratur**

- Pilotprojekte zur Spannungsregelung im NS-Netz der Thüringer Energie. **DIPL.-ING. TORSTEN RO-SCHER.** VDE-Symposium. Thüringer Energie AG aus Erfurt, 18. September 2013
- **SCHNEIDER ELECTRIC ENERGY GMBH.** Die intelligente Ortsnetzstation - Ein wichtiger Smart Grid-Baustein. *SEEDEFOSMARTKIOSK_12-12_1.1,* 2012, 7
- FITformer® REG - Der regelbare Ortsnetztransformator. *Bestell-Nr. E50001-G640-A220-V2, TH 101-140819 DB 10140.3,* 2014